(19) **Europäisches Patentamt / European Patent Office / Office européen des brevets**

(11) **EP 1 768 169 B1**

(12) **EUROPEAN PATENT SPECIFICATION**

(45) Date of publication and mention
of the grant of the patent:
**24.10.2012 Bulletin 2012/43**

(21) Application number: **05745697.2**

(22) Date of filing: **03.06.2005**

(51) Int Cl.:
*H01L 21/027* (2006.01)      *G03F 7/20* (2006.01)

(86) International application number:
**PCT/JP2005/010217**

(87) International publication number:
**WO 2005/119742 (15.12.2005 Gazette 2005/50)**

(54) **EXPOSURE APPARATUS, EXPOSURE METHOD, AND DEVICE PRODUCING METHOD**

BELICHTUNGSVORRICHTUNG, BELICHTUNGSVERFAHREN UND VERFAHREN ZUR
HERSTELLUNG EINES BAUELEMENTES

APPAREIL ET PROCÉDÉ D'EXPOSITION, ET PROCÉDÉ DE PRODUCTION D'UN DISPOSITIF

(84) Designated Contracting States:
**AT BE BG CH CY CZ DE DK EE ES FI FR GB GR
HU IE IS IT LI LT LU MC NL PL PT RO SE SI SK TR**

(30) Priority: **04.06.2004 JP 2004167115**

(43) Date of publication of application:
**28.03.2007 Bulletin 2007/13**

(73) Proprietor: **NIKON CORPORATION**
**Chiyoda-ku**
**Tokyo 100-8331 (JP)**

(72) Inventor: **NISHII, Yasufumi**
**Chiyoda-ku,**
**Tokyo 1008331 (JP)**

(74) Representative: **Wiebusch, Manfred**
**ter Meer Steinmeister & Partner GbR**
**Artur-Ladebeck-Strasse 51**
**33617 Bielefeld (DE)**

(56) References cited:
| | |
|---|---|
| EP-A- 1 510 871 | EP-A- 1 571 698 |
| EP-A- 1 670 043 | EP-A1- 1 420 302 |
| WO-A-2004/107048 | DD-A1- 224 448 |
| JP-A- 10 303 114 | JP-A- 2004 193 252 |
| JP-A- 2005 093 997 | JP-A- 2005 116 571 |
| JP-A- 2005 191 381 | JP-A- 2007 012 867 |

**Description**

TECHNICAL FIELD

The present invention relates to an exposure apparatus for exposing a substrate, an exposure method, and a method for producing a device.

BACKGROUND ART

An exposure apparatus according to the preamble of claim 1 is described in DE 224 448 A1.
An exposure method according to the preamble of claim 29 is disclosed in WO 2004/107048 A.
Similar apparatus and methods are discussed in EP 1 510 871 A, EP 1 670 043 A, EP 1 571 698 A, JP 10 303114 A and EP 1 420 303 A1.
Semiconductor devices and liquid crystal display devices are produced by means of the so-called photolithography technique in which a pattern formed on a mask is transferred onto a photosensitive substrate. The exposure apparatus, which is used in the photolithography step, includes a mask stage for supporting the mask and a substrate stage for supporting the substrate. The pattern on the mask is transferred onto the substrate via a projection optical system while successively moving the mask stage and the substrate stage. In recent years, it is demanded to realize the higher resolution of the projection optical system in order to respond to the further advance of the higher integration of the device pattern. As the exposure wavelength to be used is shorter, the resolution of the projection optical system becomes higher. As the numerical aperture of the projection optical system is larger, the resolution of the projection optical system becomes higher. Therefore, the exposure wavelength, which is used for the exposure apparatus, is shortened year by year, and the numerical aperture of the projection optical system is increased as well. The exposure wavelength, which is dominantly used at present, is 248 nm of the KrF excimer laser. However, the exposure wavelength of 193 nm of the ArF excimer laser, which is shorter than the above, is also practically used in some situations. When the exposure is performed, the depth of focus (DOF) is also important in the same manner as the resolution. The resolution R and the depth of focus $\delta$ are represented by the following expressions respectively.
$$R = k_1 \cdot \lambda / NA \qquad \ldots (1)$$

$$\delta = \pm k_2 \cdot \lambda / NA^2 \qquad \ldots (2)$$

In the expressions, $\lambda$ represents the exposure wavelength, NA represents the numerical aperture of the projection optical system, and $k_1$ and $k_2$ represent the process coefficients. According to the expressions (1) and (2), the following fact is appreciated. That is, when the exposure wavelength $\lambda$ is shortened and the numerical aperture NA is increased in order to enhance the resolution R, then the depth of focus $\delta$ is narrowed.

If the depth of focus $\delta$ is too narrowed, it is difficult to match the substrate surface with respect to the image plane of the projection optical system. It is feared that the focus margin is insufficient during the exposure operation. Accordingly, the liquid immersion method has been suggested, which is disclosed, for example, in International Publication No. 99/49504 as a method for substantially shortening the exposure wavelength and widening the depth of focus. In this liquid immersion method, the space between the end surface (lower surface) on the image plane side of the projection optical system and the substrate surface is filled with a liquid such as water or any organic solvent to form a liquid immersion area so that the resolution is improved and the depth of focus is magnified about n times by utilizing the fact that the wavelength of the exposure light beam in the liquid is 1/n as compared with that in the air (n represents the refractive index of the liquid, which is about 1.2 to 1.6 in ordinary cases).

When the liquid immersion area is formed with the liquid on the substrate, there is such a possibility that the liquid of the liquid immersion area may be mixed with any impurity or the like which is generated, for example, from the substrate, and the liquid of the liquid immersion area may be contaminated therewith. In such a situation, there is such a possibility that the optical element, which is included in a plurality of elements (optical elements) for constructing the projection optical system and which makes contact with the contaminated liquid of the liquid immersion area, may be polluted with the contaminated liquid of the liquid immersion area. If the optical element is polluted, any inconvenience arises, for example, such that the light transmittance of the optical element is lowered and/or any distribution appears in the light transmittance. As a result, the exposure accuracy and the measurement accuracy, which are obtained through the projection optical system, are deteriorated.

DISCLOSURE OF THE INVENTION

Problem to Be Solved by the Invention:

The present invention has been made taking the foregoing circumstances into consideration, an object of which is to provide an exposure apparatus and an exposure method with which it is possible to avoid the deterioration of the exposure accuracy and the measurement accuracy, and a method for producing a device using the exposure apparatus and the exposure method.

Means for Solving the Problem and Effect of the Invention:

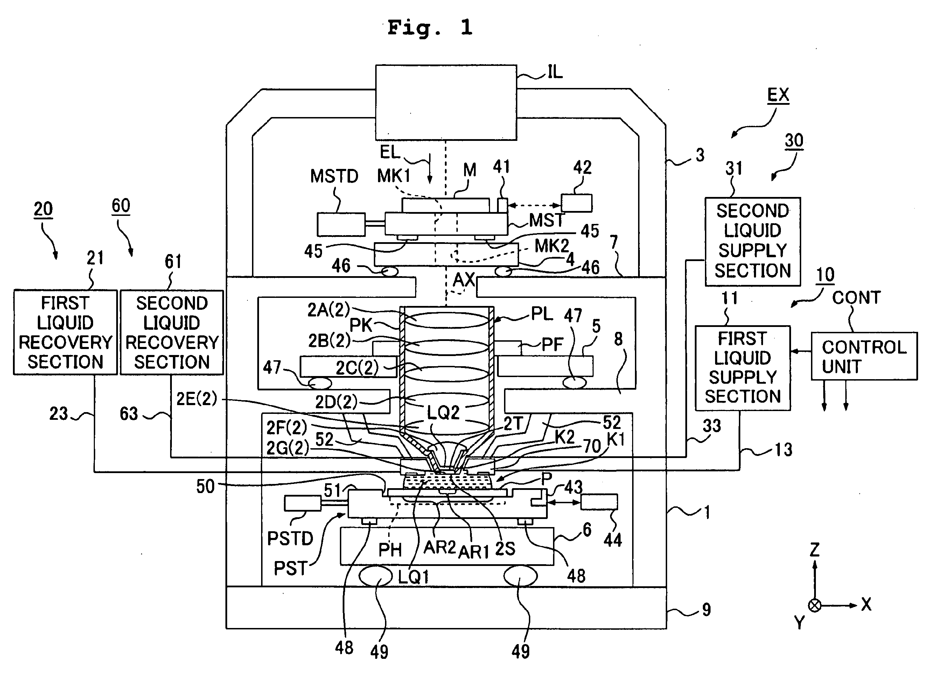

In order to achieve the object as described above, the present invention adopts the following constructions corresponding to Figs. 1 to 8 as illustrated in embodiments. However, parenthesized reference numerals affixed to respective elements merely exemplify the elements by way of example, with which it is not intended to limit the respective elements.

According to the present invention, there is provided an exposure apparatus as specified in claim 1.

According to the present invention, the substrate can be exposed satisfactorily in a state in which the large image side numerical aperture is secured by filling, with the liquid, the first and second spaces disposed on the sides of one surface and the other surface of the first element respectively. For example, when the liquid, with which the first space is filled, makes contact with the substrate, there is a high possibility that one surface side of the first element may be polluted. However, in this arrangement, the first element can be made easily exchangeable. Therefore, it is enough that only the polluted first element is exchanged with a clean element. The exposure and the measurement can be performed satisfactorily via the liquid and the projection optical system provided with the clean first element.

The first element, which is referred to in the present invention, may be a transparent member having no refractive power (for example, a parallel flat plate or plane parallel plate). For example, even when the transparent member, which is arranged on the side most closely to the image plane, does not contribute to the image formation performance of the projection optical system at all, the transparent member is regarded as the first element.

The first element, which is referred to in the present invention, is supported in the substantially stationary state with respect to the optical axis of the projection optical system. However, even when the first element is supported finely movably in order to adjust the posture and/or the position thereof, it is regarded that the first element is "supported in the substantially stationary state".

According to the present invention, the first and second spaces can be easily filled with the liquid respectively via the connecting hole by allowing the liquid supply mechanism to supply the liquid to one of the first space disposed on the side of one surface of the first element and the second space disposed on the side of the other surface. The substrate can be exposed satisfactorily in a state in which the large image side numerical aperture is secured by filling, with the liquid, the first and second spaces on the sides of one surface and the other surface of the first element respectively. For example, when the liquid, with which the first space is filled, makes contact with the substrate, there is a high possibility that one surface side of the first element may be polluted. However, in this arrangement, the first element can be made easily exchangeable. Therefore, it is enough that only the polluted first element is exchanged with a clean element. The exposure and the measurement can be performed satisfactorily via the liquid and the projection optical system provided with the clean first element.

The first element, which is referred to in the present invention, may be a transparent member having no refractive power (for example, a parallel flat plate or plane parallel plate). For example, even when the transparent member, which is arranged on the side most closely to the image plane, does not contribute to the image formation performance of the projection optical system at all, the transparent member is regarded as the first element.

According to the present invention, there is provided a method for producing a device, comprising using the exposure apparatus according to any one of the first and second aspects.

According to the present invention, it is possible to produce the device having desired performance, because the exposure accuracy and the measurement accuracy can be maintained satisfactorily.

According to the present invention, there is provided an exposure method as specified in claim 29.

According to the exposure method of the present invention, the liquid is provided to the first space disposed on the light-exit side of the first element and the second space disposed on the light-incident side, and the exposure light beam is radiated through the liquid contained in the spaces to expose the substrate. Therefore, the substrate can be exposed in a state in which the large image side numerical aperture is secured. When the first element is provided as a detachable element, the element can be washed (cleaned) or exchanged with ease even when the first element is polluted with the liquid in the first space. Further, the supply of the liquid to the second space is stopped during the period in which the substrate is exposed. Therefore, the vibration, which is caused by the supply of the liquid to the second space, is suppressed. It is possible to expose the substrate at the desired accuracy.

According to the exposure method of the present invention, the first space and the second space are communicated with each other. Therefore, it is enough that the liquid is supplied to only one of the spaces, and the liquid is recovered from only one of the spaces. Therefore, it is possible to simplify the equipment required for the liquid supply and the liquid recovery. Further, it is possible to suppress the vibration which possibly exerts any influence on the exposure operation.

BRIEF DESCRIPTION OF THE DRAWINGS

Fig. 1 shows a schematic arrangement illustrating a first embodiment of an exposure apparatus of the present invention.

Fig. 2 shows a magnified view illustrating major parts shown in Fig. 1.

Fig. 3 shows a view illustrating a nozzle member as viewed from a lower position.

Fig. 4 shows a magnified view illustrating major parts to depict an exposure apparatus of a second embodiment of the present invention.

Fig. 5 shows a magnified view illustrating major parts to depict an exposure apparatus of a third embodiment of the present invention.

Fig. 6 shows a schematic perspective view illustrating a nozzle member.

Fig. 7 shows a magnified view illustrating major parts to depict an exposure apparatus of a fourth embodiment of the present invention.

Fig. 8 shows a flow chart illustrating exemplary steps of producing a semiconductor device.

Fig. 9 illustrates the operation for recovering the liquid in relation to a first liquid recovery mechanism of an exposure apparatus according to a fifth embodiment of the present invention.

Legend for Reference Numerals:

2 (2A to 2G): optical element (element), 2S: lower surface, 2T: upper surface, 10: first liquid supply mechanism, 20: first liquid recovery mechanism, 30: second liquid supply mechanism, 60: second liquid recovery mechanism, 70: nozzle member (flow passage-forming member), 74: connecting hole, EL: exposure light beam, EX: exposure apparatus, K1: first space, K2: second space, LQ (LQ1, LQ2): liquid, P: substrate, PL: projection optical system.

BEST MODE FOR CARRYING OUT THE INVENTION

An explanation will be made below about the exposure apparatus and the exposure method of the present invention. However, the present invention is not limited thereto.

First Embodiment

Fig. 1 shows a schematic arrangement illustrating a first embodiment of an exposure apparatus of the present invention. With reference to Fig. 1, the exposure apparatus EX includes a mask stage MST which supports a mask M, a substrate stage PST which supports a substrate P, an illumination optical system IL which illuminates, with an exposure light beam EL, the mask M supported by the mask stage MST, a projection optical system PL which performs the projection exposure for the substrate P supported by the substrate stage PST with an image of a pattern of the mask M illuminated with the exposure light beam EL, and a control unit CONT which integrally controls the operation of the entire exposure apparatus EX.

The exposure apparatus EX of the embodiment of the present invention is a liquid immersion exposure apparatus to which the liquid immersion method is applied in order that the exposure wavelength is substantially shortened to improve the resolution and the depth of focus is substantially widened. The exposure apparatus EX includes a first liquid supply mechanism 10 which supplies a liquid LQ1 to the image plane side of the projection optical system PL, and a first liquid recovery mechanism 20 which recovers the liquid LQ1 on the image plane side of the projection optical system PL. The first liquid supply mechanism 10 supplies the liquid LQ1 to the first space K1 formed between the substrate P and a lower surface 2S of a last (end) optical element 2G which is closest to the image plane of the projection optical system PL among a plurality of optical elements 2 (2A to 2G) for constructing the projection optical system PL. The first liquid recovery mechanism 20 recovers the liquid LQ1 supplied to the first space K1.

The exposure apparatus EX further includes a second liquid supply mechanism 30 which supplies a liquid LQ2 to the second space K2 formed between the upper surface 2T of the last optical element 2G and an optical element 2F provided thereover, and a second liquid recovery mechanism 60 which recovers the liquid LQ2 supplied to the second space K2. The first space K1 and the second space K2 are spaces which are independent from each other. The second liquid supply mechanism 30 is capable of supplying the liquid to the second space K2 independently from the first liquid supply mechanism 10. The second liquid recovery mechanism 60 is capable of recovering the liquid from the second space K2 independently from the first liquid recovery mechanism 20.

In the case of the exposure apparatus EX, the liquid immersion area AR2, which is larger than the projection area AR1 and which is smaller than the substrate P, is locally formed on a part of the substrate P including the projection area AR1 of the projection optical system PL with the liquid LQ1 supplied from the first liquid supply mechanism 10 in a state in which the second space K2 is filled with the liquid LQ2 supplied from the second liquid supply mechanism 30 at least during the period in which the image of the pattern of the mask M is transferred onto the substrate P (during the period in which the exposure light beam EL is radiated onto the substrate P). Specifically, the exposure apparatus EX adopts the local liquid immersion system in which the first space K1 between the last optical element 2G closest to the image plane of the projection optical system PL and the surface of the substrate P arranged on the image plane side is filled with the liquid LQ1 to cover the part of the surface of the substrate P with the liquid immersion area AR2. The exposure light beam EL, which has passed through the mask M, is radiated onto the substrate P via the projection optical system PL, the liquid LQ2 in the second space K2 disposed on the side of the upper surface 2T of the last optical element 2G, and the liquid LQ1 in the first space K1 disposed on the side of the lower surface 2S of the last optical element 2G, and thus the substrate P is subjected to the projection exposure with the pattern of the mask M.

A nozzle member (flow passage-forming member) 70, which constructs parts of the first and second liquid supply mechanisms 10, 20 and the first and second liquid recovery mechanisms 30, 60, is arranged in the vicinity of the image plane of the projection optical system PL. The nozzle member 70 is an annular member which is provided to surround the lower portion of the barrel PK over or above the substrate P (substrate stage PST).

The embodiment of the present invention will be explained as exemplified by a case of the use of the scanning type exposure apparatus (so-called scanning stepper) as the exposure apparatus EX in which the substrate P is exposed with the pattern formed on the mask M while synchronously moving the mask M and the substrate P in mutually different directions (opposite directions) in the scanning directions. In the following explanation, the Z axis direction is the direction which is coincident with the optical axis AX of the projection optical system PL, the X axis direction is the synchronous movement direction (scanning direction) for the mask M and the substrate P in the plane perpendicular to the Z axis direction, and the Y axis direction is the direction (non-scanning direction) perpendicular to the Z axis direction and the X axis direction. The directions of rotation (inclination) about the X axis, the Y axis, and the Z axis are designated as $\theta X$, $\theta Y$, and $\theta Z$ directions respectively.

The illumination optical system IL illuminates, with the exposure light beam EL, the mask M supported by the mask stage MST. The illumination optical system IL includes, for example, an exposure light source, an optical integrator which uniformizes the illuminance of the light flux radiated from the exposure light source, a condenser lens which collects the exposure light beam EL emitted from the optical integrator, a relay lens system, and a variable field diaphragm which sets the illumination area on the mask M formed by the exposure light beam EL to be slit-shaped. The predetermined illumination area on the mask M is illuminated with the exposure light beam EL having a uniform illuminance distribution by the illumination optical system IL. Those usable as the exposure light beam EL radiated from the illumination optical system IL include, for example, emission lines (g-ray, h-ray, i-ray) radiated, for example, from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm) and the $F_2$ laser beam (wavelength: 157 nm). In this embodiment, the ArF excimer laser beam is used.

In this embodiment, a same pure water is used for the liquid LQ1 with which the first space K1 is filled and the liquid LQ2 with which the second space K2 is filled. Those capable of being transmitted through pure water are not limited to the ArF excimer laser beam, which also include the emission line (g-ray, h-ray, i-ray) radiated, for example, from a mercury lamp and the far ultraviolet light beam (DUV light beam) such as the KrF excimer laser beam (wavelength: 248 nm).

The mask stage MST is movable while holding the mask M. For example, the mask M is fixed by the vacuum attraction (or the electrostatic attraction). The mask stage MST is movable two-dimensionally in the plane perpendicular to the optical axis AX of the projection optical system PL, i.e., in the XY plane, and it is finely rotatable in the $\theta Z$ direction by the aid of the mask stage-driving unit MSTD including a linear motor or the like. The mask stage MST is movable at a designated scanning velocity in the X axis direction. The mask stage MST has a movement stroke in the X axis direction to such an extent that the entire surface of the mask M can traverse at least the optical axis AX of the projection optical system PL.

A movement mirror 41, which is movable together with the mask stage MST, is provided on the mask stage MST. A laser interferometer 42 is provided at a position opposed to the movement mirror 41. The position in the two-dimensional direction and the angle of rotation in the $\theta Z$ direction (including the angles of rotation in the $\theta X$ and $\theta Y$

directions in some cases) of the mask M on the mask stage MST are measured in real-time by the laser interferometer 42. The result of the measurement is outputted to the control unit CONT. The control unit CONT drives the mask stage-driving unit MSTD on the basis of the result of the measurement obtained by the laser interferometer 42 to thereby control the position of the mask M supported on the mask stage MST.

The projection optical system PL projects the pattern on the mask M onto the substrate P at a predetermined projection magnification β to perform the exposure. The projection optical system PL is constructed of the plurality of optical elements 2 (2A to 2G) including the last optical element 2G which is provided at the end portion on the side of the substrate P and the optical element 2F which is next nearest to the image plane with respect to the last optical element 2G. The plurality of optical elements 2A to 2G are supported by the barrel PK in a state in which the plurality of optical elements 2A to 2G are allowed to stand still substantially stationarily with respect to the optical axis AX. In this embodiment, the projection optical system PL is the reduction system in which the projection magnification β is, for example, 1/4, 1/5, or 1/8. The projection optical system PL may be any one of the 1x magnification system and the magnifying system. The projection optical system PL may be any one of the cata-dioptric system including dioptric and catoptric elements, the dioptric system including no catoptric element, and the catoptric system including no dioptric element.

The substrate stage PST is movable while holding the substrate P by the aid of a substrate holder PH. The substrate stage PST is movable two-dimensionally in the XY plane, and it is finely rotatable in the θZ direction. Further, the substrate stage PST is also movable in the Z axis direction, the θX direction, and the θY direction. The substrate P is held by the substrate holder PH, for example, by the vacuum attraction. The substrate stage PST is driven by the substrate stage-driving unit PSTD such as a linear motor controlled by the control unit CONT.

A movement mirror 43, which is movable together with the substrate stage PST with respect to the projection optical system PL, is provided on the substrate stage PST. A laser interferometer 44 is provided at a position opposed to the movement mirror 43. The angle of rotation and the position in the two-dimensional direction of the substrate P on the substrate stage PST are measured in real-time by the laser interferometer 44. Although not shown, the exposure apparatus EX is provided with a focus/leveling detecting system which detects the information about the position of the surface of the substrate P supported by the substrate stage PST as disclosed, for example, in Japanese Patent Application Laid-open No. 8-37149. The focus/leveling detecting system detects the information about the position in the Z axis direction of the surface of the substrate P and the information about the inclination in the θX and θY directions of the substrate P through or not through the liquid LQ1 in the first space K1. In the case of the focus/leveling detecting system which detects the surface information about the surface of the substrate P not through the liquid LQ1, the surface information about the surface of the substrate P may be detected at a position away from the projection optical system PL. An exposure apparatus, which detects the surface information about the surface of the substrate P at a position away from the projection optical system PL, is disclosed, for example, in United States Patent No. 6,674,510, contents of which are incorporated herein by reference within a range of permission of the domestic laws and ordinances of the state designated or selected in this international application.

The result of the measurement performed by the laser interferometer 44 is outputted to the control unit CONT. The light-receiving result of the focus/leveling detecting system is also outputted to the control unit CONT. The control unit CONT drives the substrate stage-driving unit PSTD on the basis of the result of the detection performed by the focus/leveling detecting system to control the focus position and the angle of inclination of the substrate P so that the surface of the substrate P is adjusted to match the image plane of the projection optical system PL. Further, the control unit CONT positions the substrate P in the X axis direction and the Y axis direction on the basis of the result of the measurement performed by the laser interferometer 44.

A recess 50 is provided on the substrate stage PST. The substrate holder PH for holding the substrate P is arranged in the recess 50. The upper surface 51 of the substrate stage PST except for the recess 50 is a flat surface (flat section) which has substantially the same height as that of (is flush with) the surface of the substrate P held by the substrate holder PH. In this embodiment, the upper surface of the movement mirror 43 is also substantially flush with the upper surface 51 of the substrate stage PST. No difference in height appears outside the edge portion of the substrate P and the liquid immersion area AR2 can be satisfactorily formed by retaining the liquid LQ on the image plane side of the projection optical system PL even when the edge area of the substrate P is subjected to the liquid immersion exposure, because the upper surface 51, which is substantially flush with the surface of the substrate P, is provided around the substrate P. It is also allowable that any small difference in height is present between the surface of the substrate P and the upper surface 51 of the substrate stage PST provided that the liquid LQ1 can be retained in the first space K1. A gap of about 0.1 to 2 mm is provided between the edge portion of the substrate P and the flat surface (upper surface) 51 provided around the substrate P. However, the liquid LQ scarcely flows into the gap owing to the surface tension of the liquid LQ. Even when the exposure is performed for the portion in the vicinity of the circumferential edge of the substrate P, it is possible to retain the liquid LQ under the projection optical system PL by the aid of the upper surface 51.

When the upper surface 51 is lyophobic or liquid-repellent, it is possible to suppress the outflow of the liquid LQ to the outside of the substrate P (outside of the upper surface 51) during the liquid immersion exposure. Further, it is possible to smoothly recover the liquid LQ after the liquid immersion exposure as well. It is possible to avoid the inconvenience which would be otherwise caused such that the liquid LQ remains on the upper surface 51. When the upper surface 51 of the substrate stage PST is formed of a material having the lyophobic or liquid-repelling property such as polytetrafluoroethylene (Teflon (trade name)), the upper surface 51 can be made lyophobic or liquid-repellent. Alternatively, the upper surface 51 may be subjected to the liquid-repelling treatment, for example, such that the upper surface 51 is coated with a liquid-repelling material including, for example, fluorine-based resin materials such as polytetrafluoroethylene, acrylic resin materials, and silicon-based resin materials, or the upper surface 51 is stuck with a thin film composed of the liquid-repelling material as described above. The area of the liquid-repelling material (liquid-repelling treatment area) may be either the entire area of the upper surface 51 or a part of the area for which the liquid-repelling property is required.

The exposure apparatus EX is provided with a barrel surface plate (barrel base plate) 5 which supports the projection optical system PL, and a main column 1 which supports the barrel surface plate 5 and the mask stage MST. The main column 1 is installed on a base 9 provided on the floor surface. The substrate stage PST is supported on the base 9. The main column 1 is formed with an upper step 7 and a lower step 8 which protrude inwardly.

The illumination optical system IL is supported by a support frame 3 fixed to an upper portion of the main column 1. A mask surface plate (mask base plate)4 is supported by the upper step 7 of the main column 1 by the aid of an anti-vibration unit 46. Openings MK1, MK2, through which the image of the pattern of the mask M are allowed to pass, are formed at central portions of the mask stage MST and the mask surface plate 4 respectively. A plurality of gas bearings (air bearings) 45, which are non-contact bearings, are provided on the lower surface of the mask stage MST. The mask stage MST is supported in a non-contact manner with respect to the upper surface (guide surface) of the mask surface plate 4 by the aid of the air bearings 45. The mask stage MST is movable two-dimensionally in the XY plane and finely rotatable in the $\theta Z$ direction by the aid of the mask stage-driving unit MSTD.

A flange PF is provided on the outer circumference of the barrel PK which holds the projection optical system PL. The projection optical system PL is supported by the barrel surface plate 5 by the aid of the flange PF. An anti-vibration unit 47, which includes an air mount or the like, is arranged between the barrel surface plate 5 and the lower step 8 of the main column 1. The barrel surface plate 5, which supports the projection optical system PL, is supported by the lower step 8 of the main column 1 by the aid of the anti-vibration unit 47. The barrel surface plate 5 and the main column 1 are isolated from each other in terms of the vibration by the anti-vibration unit 47 so that the vibration of the main column 1 is not transmitted to the barrel surface plate 5 which supports the projection optical system PL.

A plurality of gas bearings (air bearings) 48, which are non-contact bearings, are provided on the lower surface of the substrate stage PST. A substrate surface plate (substrate base plate) 6 is supported on the base 9 by the aid of an anti-vibration unit 49 including an air mount or the like. The substrate stage PST is supported in a non-contact manner with respect to the upper surface (guide surface) of the substrate surface plate 6 by the aid of the air bearings 48. The substrate stage PST is movable two-dimensionally in the XY plane and finely rotatable in the $\theta Z$ direction by the aid of the substrate stage-driving unit PSTD. The substrate surface plate 6 is isolated from the main column 1 and the base 9 (floor surface) in terms of the vibration by the anti-vibration unit 49 so that the vibration of the base 9 (floor surface) and/or the main column 1 is not transmitted to the substrate surface plate 6 which supports the substrate stage PST in the non-contact manner.

The nozzle member 70 is supported by the lower step 8 of the main column 1 by the aid of a connecting member 52. The connecting member 52 is fixed to the lower step 8 of the main column 1. The nozzle member 70 is fixed to the connecting member 52. The lower step 8 of the main column 1 supports the projection optical system PL by the aid of the anti-vibration unit 47 and the barrel surface plate 5. In this arrangement, the nozzle member 70 is supported by the lower step 8 which supports the projection optical system PL.

The main column 1, which supports the nozzle member 70 by the aid of the connecting member 52, is isolated by the aid of the anti-vibration unit 47 in terms of the vibration from the barrel surface plate 5 which supports the barrel PK of the projection optical system PL by the aid of the flange PF. Therefore, the projection optical system PL is prevented from any transmission of the vibration generated by the nozzle member 70. Further, the main column 1, which supports the nozzle member 70 by the aid of the connecting member 52, is isolated by the aid of the anti-vibration unit 49 in terms of the vibration from the substrate surface plate 6 which supports the substrate stage PST. Therefore, the substrate stage PST is prevented from any transmission of the vibration generated by the nozzle member 70 via the main column 1 and the base 9. Further, the main column 1, which supports the nozzle member 70 by the aid of the connecting member 52, is isolated by the aid of the anti-vibration unit 46 in terms of the vibration from the mask surface plate 4 which supports the mask stage MST. Therefore, the mask stage MST is prevented from any transmission of the vibration generated by the nozzle member 70 via the main column 1.

The first liquid supply mechanism 10 supplies the liquid LQ1 to the first space K1 formed on the side of the lower surface 2S of the last optical element 2G of the projection optical system PL (on the light-exit side). The first liquid supply mechanism 10 is provided with a first liquid supply section 11 which is capable of feeding the liquid LQ1, and a supply tube 13 which has one end connected to the first liquid supply section 11. The first liquid supply section 11 includes, for example, a tank for accommodating the liquid LQ1, a temperature-adjusting unit for adjusting the temperature of the liquid LQ1 to be supplied, a filter unit for removing any foreign matter from the liquid LQ1, and a pressurizing pump. When the liquid immersion area AR2 is formed on the substrate P, the liquid supply mechanism 10 supplies the liquid LQ1 onto the substrate P.

The first liquid recovery mechanism 20 recovers the liquid LQ1 supplied to the first space K1 formed on the side of the lower surface 2S of the last optical element 2G. The first liquid recovery mechanism 20 is provided with a first liquid recovery section 21 which is capable of recovering the liquid LQ1, and a recovery tube 23 which has one end connected to the first liquid recovery section 21. The first liquid recovery section 21 includes, for example, a vacuum system (suction unit) such as a vacuum pump, a gas/liquid separator for separating the recovered liquid LQ1 and the gas from each other, and a tank for accommodating the recovered liquid LQ1. The equipment of the factory or the like in which the exposure apparatus EX is arranged may be used without providing at least a part or parts of the vacuum system, the gas/liquid separator, the tank, and other components for the exposure apparatus EX. In order to form the liquid immersion area AR2 on the substrate P, a predetermined amount of the liquid LQ1 supplied by the first liquid supply mechanism 10 is recovered from the surface of the substrate P by the first liquid recovery mechanism 20.

The second liquid supply mechanism 30 supplies the liquid LQ2 to the second space K2 formed on the side of the upper surface 2T of the last optical element 2G of the projection optical system PL. The second liquid supply mechanism 30 is provided with a second liquid supply section 31 which is capable of feeding the liquid LQ2, and a supply tube 33 which has one end connected to the second liquid supply section 31. The second liquid supply section 31 includes, for example, a tank for accommodating the liquid LQ2, a temperature-adjusting unit for adjusting the temperature of the liquid LQ2 to be supplied, a filter unit for removing any foreign matter from the liquid LQ2, and a pressurizing pump. It is not necessary indispensable that at least a part or parts of the tank and the pressurizing pump of each of the first liquid supply section 11 and the second liquid supply section 31 are provided for the exposure apparatus EX, which may be replaced with the equipment of the factory or the like in which the exposure apparatus EX is installed as well.

The second liquid recovery mechanism 60 recovers the liquid LQ2 supplied to the second space K2 formed on the side of the upper surface 2T of the last optical element 2G. The second liquid recovery mechanism 60 is provided with a second liquid recovery section 61 which is capable of recovering the liquid LQ2, and a recovery tube 63 which has one end connected to the second liquid recovery section 61. The second liquid recovery section 61 includes, for example, a vacuum system (suction unit) such as a vacuum pump, a gas/liquid separator for separating the recovered liquid LQ2 and the gas from each other, and a tank for accommodating the recovered liquid LQ2. The equipment of the factory or the like in which the exposure apparatus EX is arranged may be used without providing at least a part or parts of the vacuum system, the gas/liquid separator, the tank, and other components for the exposure apparatus EX.

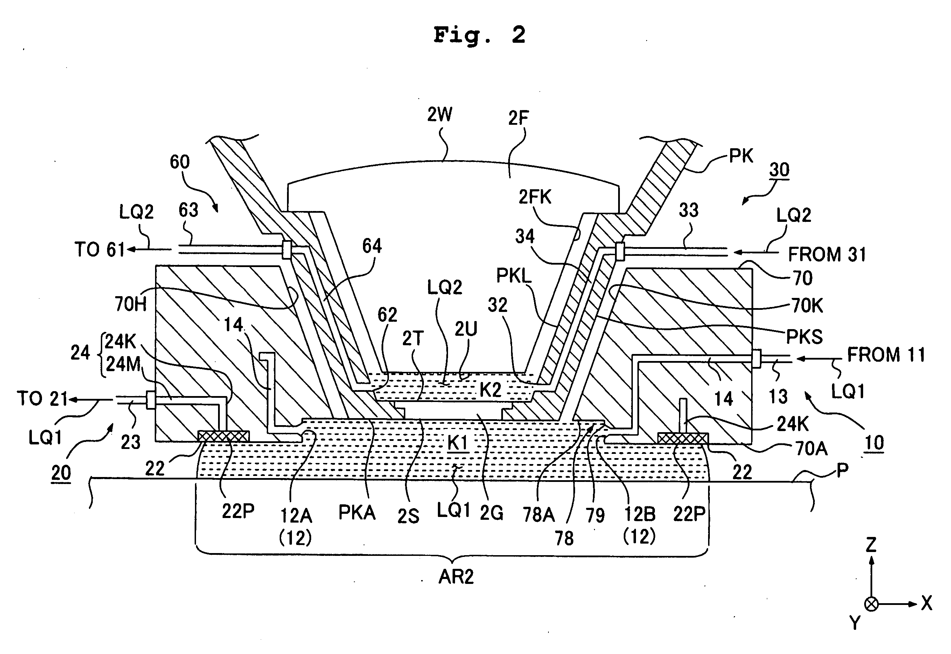

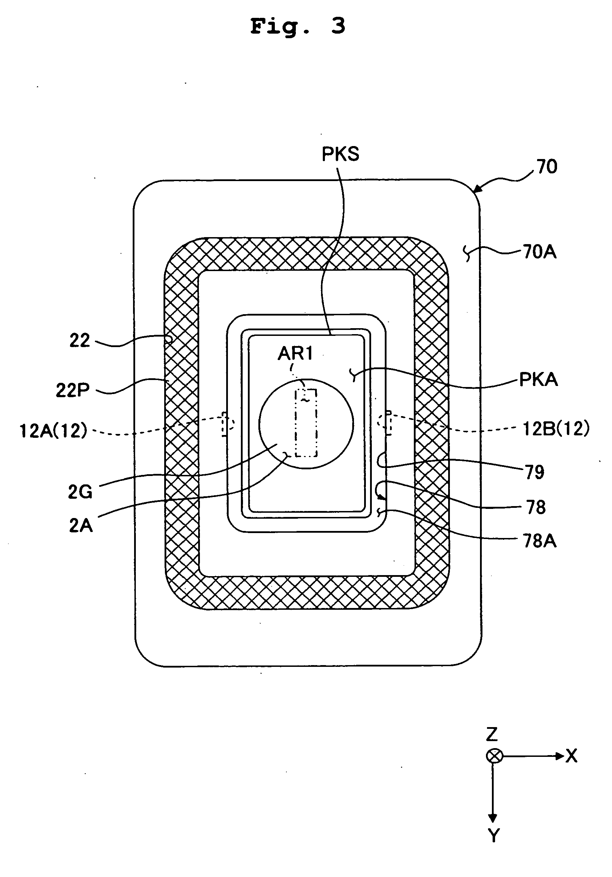

Fig. 2 shows a sectional view illustrating the side of the image plane of the projection optical system PL and illustrating the vicinity of the nozzle member 70. Fig. 3 shows a view illustrating the nozzle member 70 as viewed from a lower position.

With reference to Figs. 2 and 3, the last optical element 2G and the optical element 2F arranged thereabove are supported by the barrel PK. The last optical element 2G is the parallel flat plate. The lower surface PKA of the barrel PK is substantially flush with the lower surface 2S of the last optical element 2G held by the barrel PK. The upper surface 2T and the lower surface 2S of the last optical element 2G supported by the barrel PK are substantially in parallel to the XY plane. The last optical element (parallel flat plate) 2G is supported substantially horizontally, and it has no refractive power. For example, the connecting portion between the barrel PK and the last optical element 2G is sealed. That is, the first space K1 disposed on the side of the lower surface 2S of the last optical element 2G and the second space K2 disposed on the side of the upper surface 2T of the last optical element 2G are mutually independent spaces. The flow of the liquid is blocked between the first space K1 and the second space K2. As described above, the first space K1 is the space between the last optical element 2G and the substrate P, and the liquid immersion area AR2 of the liquid LQ1 is formed in the first space K1. The first space is open in the direction parallel to the substrate, i.e., the surroundings of the first space are open. Therefore, the interface of the liquid LQ1 retained between the nozzle member 70 and the substrate P makes contact with the surrounding gas. On the other hand, the second space K2 is a part of the internal space of the barrel PK. The second space K2 is the space between the upper surface 2T of the last optical element 2G and the lower surface 2U of the optical element 2F arranged thereabove. The second space K2 is closed in the direction parallel to the substrate, i.e., the surroundings of the second space K2 are closed by the wall surfaces of the barrel PK. However, a part of the upper surface of the liquid LQ2 of the second space K2 makes contact with the gas in the gap between the barrel PK and the optical element 2F.

The areal size of the upper surface 2T of the last optical element 2G is approximately the same as the areal size of the lower surface 2U of the optical element 2F opposed to the upper surface 2T, or the areal size of the upper surface 2T is smaller than the areal size of the lower surface 2U. When the second space K2 is filled with the liquid LQ, substantially the entire surface of the upper surface 2T of the last optical element 2G is covered with the liquid LQ.

The last optical element 2G can be easily attached/detached with respect to the barrel PK. That is, the last optical element 2G is provided exchangeably. In particular, when the last optical element 2G is attached or detached, the last optical element 2G can be attached to the barrel PK without disengaging any other optical element in the barrel PK and without exerting any influence on the optical characteristic of the other optical element or the projection optical system. For example, when the barrel PK has such a structure that the barrel PK is separated into a first holding member for holding the optical element 2F and a second holding member for holding the last optical element 2G, and the second holding member is fixed to the first holding member by using screws or the like, then the last optical element 2G can be exchanged with ease by detaching the second holding member.

The nozzle member 70 is the annular member which is arranged in the vicinity of the lower end of the projection optical system PL and which is provided to surround the barrel PK above the substrate P (substrate stage PST). The nozzle member 70 constructs parts of the first liquid supply mechanism 10 and the first liquid recovery mechanism 20 respectively. The nozzle member 70 has a hole 70H which is disposed at a central portion thereof and in which the projection optical system PL (barrel PK) can be arranged. In this embodiment, the projection area AR1 of the projection optical system PL is set to have a rectangular shape in which the Y axis direction (non-scanning direction) is the longitudinal direction.

A recess 78, in which the Y axis direction is the longitudinal direction, is formed on the lower surface 70A of the nozzle member 70 opposed to the substrate P. The hole 70H, in which the projection optical system PL (barrel PK) can be arranged, is formed inside the recess 78. A surface 78A (hereinafter referred to as "cavity surface 78A"), which is substantially parallel to the XY plane and which is opposed to the substrate P supported by the substrate stage PST, is provided inside the recess 78. The recess 78 has an inner side surface 79. The inner side surface 79 is provided to be substantially perpendicular to the surface of the substrate P supported by the substrate stage PST. In this arrangement, the substrate stage PST supports the substrate P so that the surface of the substrate P is substantially in parallel to the XY plane.

First supply ports 12 (12A, 12B), which constructs parts of the first liquid supply mechanism 10, are provided on the inner side surface 79 of the recess 78 of the lower surface 70A of the nozzle member 70. In this embodiment, two of the first supply ports 12 (12A, 12B) are provided, which are disposed on the both sides in the X axis direction respectively with the optical element 2 (projection area AR1) of the projection optical system PL intervening therebetween. Each of the first supply ports 12A, 12B discharges the liquid LQ1 fed from the first liquid supply section 11 substantially in parallel to the surface of the substrate P arranged on the image plane side of the projection optical system PL, i.e., substantially in parallel to the XY plane (in the lateral direction).

In this embodiment, the first supply ports 12A, 12B are formed to be substantially circular. However, the first supports 12A, 12B may be formed to have arbitrary shapes including, for example, elliptical, rectangular, and slit shapes. In this embodiment, the first supply ports 12A, 12B mutually have approximately the same size. However, the first supply ports 12A, 12B may have mutually different sizes. The first supply port may be provided at one place. The first supply ports 12A, 12B may be provided on the both sides in the Y axis direction respectively with respect to the optical element 2 (projection area AR1) of the projection optical system PL.

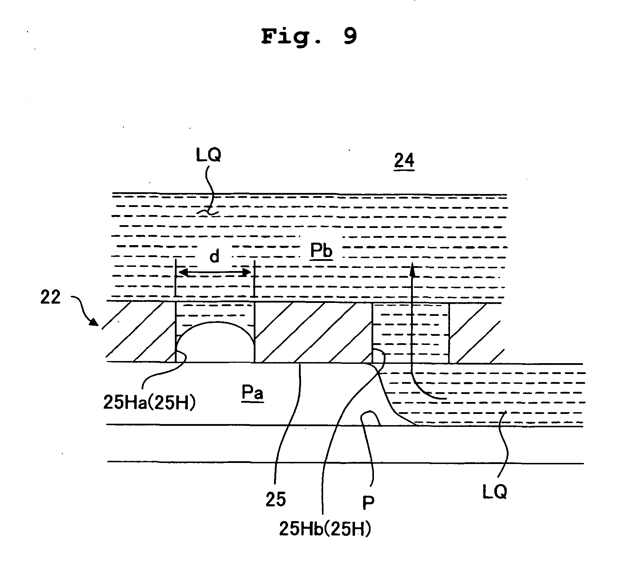

A first recovery port 22, which constructs a part of the first liquid recovery mechanism 20, is provided outside the recess 78 with reference to the projection area AR1 of the projection optical system PL on the lower surface 70A of the nozzle member 70. The first recovery port 22 is provided outside of the first supply ports 12A, 12B of the first liquid supply mechanism 10, with respect to the projection area AR1 of the projection optical system PL, on the lower surface 70A of the nozzle member 70 opposed to the substrate P, i.e., separately from the first supply ports 12A, 12B with respect to the projection area AR1. The first recovery port 22 is formed annularly to surround the projection area AR1 and the first supply ports 12A, 12B. A porous material 22P is provided in the first recovery port 22. The porous material 22P will be explained in relation to Fig. 9 in an embodiment described later on. It is not necessarily indispensable that the first recovery port 22 is provided annularly to surround the projection area AR1 and the first supply ports 12A, 12B. For example, the first recovery port 22 may be provided discretely. That is, for example, the number, the arrangement, and the shape of the first recovery port 22 are not limited to those described above. Any structure may be employed provided that the liquid LQ1 can be recovered so that the liquid LQ1 does not leak out.

The nozzle member 70, which is supported by the lower step 8 of the main column 1 by the aid of the connecting member 52, is separated from the projection optical system PL (barrel PK). That is, a gap is provided between the inner side surface 70K of the hole 70H of the nozzle member 70 and a side surface PKS of the barrel PK. The gap is provided in order to isolate the projection optical system PL from the nozzle member 70 in terms of the vibration. Accordingly, the vibration, which is generated in the nozzle member 70, is prevented from being transmitted to the projection optical system PL. As described above, the main column 1 (lower step 8) and the barrel surface plate 5 are isolated from each other in terms of the vibration by the aid of the anti-vibration unit 47. Therefore, the vibration, which is generated in the nozzle member 70, is prevented from being transmitted to the projection optical system PL via the main column 1 and the barrel surface plate 5.

As shown in Fig. 2, the other end of the supply tube 13 is connected to one end of a first supply flow passage 14 formed in the nozzle member 70. On the other hand, the other end of the first supply flow passage 14 of the nozzle member 70 is connected to the first supply ports 12 formed on the inner side surface 79 of the recess 78 of the nozzle member 70. In this arrangement, the first supply flow passage 14, which is formed in the nozzle member 70, is branched at an intermediate position so that the other ends can be connected to the plurality of (two) supply ports 12 (12A, 12B) respectively. As shown in Fig. 2, the portion of the first supply flow passage 14 connected to the first supply port 12, which is disposed in the vicinity of the first supply port 12, is formed to provide an inclined surface which is gradually widened toward the first supply port 12. The supply port 12 is formed to be funnel-shaped or trumpet-shaped.

The operation of the first liquid supply section 11 for supplying the liquid is controlled by the control unit CONT. In order to form the liquid immersion area AR2, the control unit CONT feeds the liquid LQ1 from the first liquid supply section 11 of the first liquid supply mechanism 10. The liquid LQ1, which is fed from the first liquid supply section 11, flows through the supply tube 13, and then the liquid LQ1 flows into one end of the first supply flow passage 14 formed in the nozzle member 70. The liquid LQ1, which has flown into one end of the first supply flow passage 14, is branched into two flows at the intermediate position, and then the liquid LQ1 is supplied to the first space K1 between the last optical element 2G and the substrate P from the plurality of (two) first supply ports 12A, 12B formed on the inner side surface 79 of the nozzle member 70. In this embodiment, the liquid LQ1, which is supplied from the first supply ports 12, flows substantially in parallel to the surface of the substrate P. Therefore, the force, which is exerted on the substrate P by the supplied liquid LQ1, can be reduced, for example, as compared with an arrangement in which the liquid LQ1 is supplied downwardly to the surface of the substrate P from any upper position over the surface of the substrate P. Therefore, it is possible to avoid the occurrence of the inconvenience which would be otherwise caused, for example, such that the substrate P and the substrate stage PST are deformed due to the supply of the liquid LQ1. Of course, the first supply port may be formed so that the liquid LQ1 is supplied downwardly taking the pressure exerted on the substrate P and the substrate stage PST into consideration.

As shown in Fig. 2, the other end of the recovery tube 23 is connected to one end of a manifold flow passage 24M which constitutes a part of a first recovery flow passage 24 formed in the nozzle member 70. On the other hand, the other end of the manifold flow passage 24M is formed to be annular as viewed in a plan view to correspond to the first recovery port 22, and is connected to an annular flow passage 24K for constructing a part of the first recovery flow passage 24 connected to the first recovery port 22.

The operation of the first liquid recovery section 21 for recovering the liquid is controlled by the control unit CONT. In order to recover the liquid LQ1, the control unit CONT drives the first liquid recovery section 21 of the first liquid recovery mechanism 20. When the first liquid recovery section 21, which has the vacuum system, is driven, the liquid LQ1 on the substrate P flows vertically upwardly (in the +Z direction) into the annular flow passage 24K via the first recovery port 22 provided over the substrate P. The liquid LQ1, which has flown into the annular flow passage 24K in the +Z direction, is collected by the manifold flow passage 24M, and then the liquid LQ1 flows through the manifold flow passage 24M. After that, the liquid LQ1 is sucked and recovered by the first liquid recovery section 21 via the recovery tube 23.

A second supply port 32, which constructs a part of the second liquid supply mechanism 30, is provided in an inner side surface PKL of the barrel PK. The second supply port 32 is formed in the vicinity of the second space K2 in the inner side surface PKL of the barrel PK, and is provided on the +X side with respect to the optical axis AX of the projection optical system PL. The liquid LQ2, which is fed from the second liquid supply section 31, flows through the second supply port 32 substantially in parallel to the upper surface 2T of the last optical element 2G, i.e., substantially in parallel to the XY plane (in the lateral direction). The force, which is exerted by the supplied liquid LQ1, for example, on the optical elements 2G, 2F, can be reduced, because the second supply port 32 discharges the liquid LQ2 substantially in parallel to the upper surface 2T of the last optical element 2G. Therefore, it is possible to avoid the occurrence of the inconvenience which would be otherwise caused, for example, such that the optical elements 2G, 2F are deformed and/or displaced due to the supply of the liquid LQ2.

A second recovery port 62, which constructs a part of the second liquid recovery mechanism 60, is provided, at a predetermined position with respect to the second supply port 32 in the inner side surface PKL of the barrel PK. The second recovery port 62 is formed in the vicinity of the second space K2, in the inner side surface PKL of the barrel PK, and is provided on the -X side with respect to the optical axis AX of the projection optical system PL. That is, the second supply port 32 and the second recovery port 62 are opposed to each other. In this embodiment, the second supply port 32 and the second recovery port 62 are formed to be slit-shaped respectively. The second supply port 32 and the second recovery port 62 may be formed to have arbitrary shapes including, for example, substantially circular, elliptical, and rectangular shapes. In this embodiment, the second supply port 32 and the second recovery port 62 mutually have approximately the same size respectively. However, the second supply port 32 and the second recovery port 62 may have mutually different sizes. The second supply port 32 may be formed to be funnel-shaped or trumpet-shaped in the same manner as the first supply port 12.

As shown in Fig. 2, the other end of the supply tube 33 is connected to one end of a second supply flow passage 34 formed in the barrel PK. On the other hand, the other end of the second supply flow passage 34 of the barrel PK is connected to the second supply port 32 formed in the inner side surface PKL of the barrel PK.

The operation of the second liquid supply section 31 for supplying the liquid is controlled by the control unit CONT. When the control unit CONT feeds the liquid LQ2 from the second liquid supply section 31 of the second liquid supply mechanism 30, then the liquid LQ2, which is fed from the second liquid supply section 31, flows through the supply tube 33, and then the liquid LQ2 flows into one end of the second supply flow passage 34 formed in the barrel PK. The liquid LQ2, which has flown into one end of the second supply flow passage 34, is supplied to the second space K2 between the optical element 2F and the last optical element 2G from the second supply port 32 formed in the inner side surface PKL of the barrel PK.

As shown in Fig. 2, the other end of the recovery tube 63 is connected to one end of a second recovery flow passage 64 formed in the barrel PK. On the other hand, the other end of the second recovery flow passage 64 is connected to the second recovery port 62 formed in the inner side surface PKL of the barrel PK.

The operation of the second liquid recovery section 61 for recovering the liquid is controlled by the control unit CONT. In order to recover the liquid LQ2, the control unit CONT drives the second liquid recovery section 61 of the second liquid recovery mechanism 60. When the second liquid recovery section 61, which has the vacuum system, is driven, the liquid LQ2 in the second space K2 flows into the second recovery flow passage 64 via the second recovery port 62. After that, the liquid LQ2 is sucked and recovered by the second liquid recovery section 61 via the recovery tube 63. For example, the numbers and the arrangements of the second supply port 32 and the second recovery port are not limited to those described above. Any structure may be employed provided that the optical path for the exposure light beam EL between the optical element 2F and the optical element 2G is filled with the second liquid LQ2.

In this embodiment, the flow passages 34, 64 are formed in the barrel PK. However, a through-hole may be provided at a part of the barrel PK, and a piping to serve as the flow passage may be allowed to pass therethrough. In this embodiment, the supply tube 33 and the recovery tube 63 are provided separately from the nozzle member 70. However, a supply passage and a recovery passage may be provided in the nozzle member 70 in place of the supply tube 33 and the recovery tube 63, and they may be connected to the flow passages 34, 64 formed in the barrel PK respectively.

The optical element 2F, which is held by the barrel PK, has the lower surface 2U which is formed to have the flat surface shape that is substantially in parallel to the upper surface 2T of the last optical element 2G. On the other hand, the upper surface 2W of the optical element 2F is formed to be convex toward the side of the object plane (toward the mask M), and has a positive refractive index. Accordingly, the reflection loss of the light beam (exposure light beam EL) which comes into the upper surface 2W is reduced, and the large image side numerical aperture of the projection optical system PL is consequently secured. The optical element 2F, which has the refractive index (lens function), is tightly fixed to the barrel PK in the state in which the optical element 2F is satisfactorily positioned.

The liquid LQ2, with which the second space K2 is filled, makes contact with the lower surface 2U of the optical element 2F and the upper surface 2T of the last optical element 2G. The liquid LQ1 in the first space K1 makes contact with the lower surface 2S of the last optical element 2G. In this embodiment, at least the optical elements 2F, 2G are formed of silica glass. The silica glass has the high affinity for the liquid LQ1, LQ2 as water. Therefore, the liquid LQ1, LQ2 is successfully allowed to make tight contact with the substantially entire surfaces of the lower surface 2U of the optical element 2F and the upper surface 2T and the lower surface 2S of the last optical element 2G as the liquid contact surfaces. Therefore, the liquid contact surfaces 2S, 2T, 2U of the optical elements 2F, 2G are allowed to make tight contact with the liquid LQ1, LQ2, and thus it is possible to reliably fill, with the liquid LQ1, LQ2, the optical path between the optical element 2F and the last optical element 2G and the optical path between the last optical element 2G and the substrate P.

The size of the optical element 2F or the like can be decreased, because the silica glass is the material having the large refractive index. It is possible to realize the compact sizes of the entire projection optical system PL and the entire exposure apparatus EX. Further, the silica glass is water resistant. Therefore, for example, even when the pure water is used as the liquid LQ1, LQ2 as in the embodiment of the present invention, an advantage is obtained, for example, such that it is unnecessary to provide any protective film for the liquid contact surfaces 2S, 2T, 2U.

At least one of the optical elements 2F, 2G may be calcium fluorite which has the high affinity for water. In this case, it is desirable that a protective film is formed on the liquid contact surface of the calcium fluorite in order to avoid any dissolution into water. Alternatively, for example, the optical elements 2A to 2E may be formed of calcium fluorite, and the optical elements 2F, 2G may be formed of silica glass. Further alternatively, all of the optical elements 2A to 2G may be formed of silica glass (or calcium fluorite).

A hydrophilic or water-attracting (lyophilic or liquid-attracting) treatment may be applied to the liquid contact surfaces 2S, 2T, 2U of the optical elements 2F, 2G by adhering, for example, $MgF_2$, $Al_2O_3$, or $SiO_2$ to further enhance the affinity for the liquid LQ1, LQ2. In this embodiment, the liquid LQ1, LQ2 is water having the high polarity. Therefore, for example, a thin film may be formed with a substance having a molecular structure with large polarity such as alcohol, as the liquid-attracting treatment (water-attracting treatment). Accordingly, it is also possible to add the hydrophilicity to the liquid contact surfaces 2S, 2T, 2U of the optical elements 2F, 2G. That is, when the water is used as the liquid LQ1, LQ2, it is desirable to adopt the treatment in which the substance having the molecular structure with the large polarity such as the OH group is provided on the liquid contact surfaces 2S, 2T, 2U.

In this embodiment, the inner side surface PKL of the barrel PK and the side surface 2FK of the optical element 2F are subjected to the liquid-repelling treatment to have the liquid-repelling property respectively. When the inner side surface PKL of the barrel PK and the side surface 2FK of the optical element 2F are liquid-repellent respectively, then the gap formed by the inner side surface PKL and the side surface 2FK is prevented from any inflow of the liquid LQ2 of the second space K2, and the gas in the gap is prevented from being mixed as the bubble into the liquid LQ2 of the second space K2.

The liquid-repelling treatment described above includes, for example, the treatment in which a liquid-repelling material such as fluorine-based materials such as polytetrafluoroethylene, acrylic resin materials, and silicon-based resin materials is coated, and the treatment in which a thin film formed of the liquid-repelling material as described above is stuck.

When the liquid-repelling treatment is applied to the side surface PKS of the barrel PK and the inner side surface 70K of the nozzle member 70 respectively so that the side surface PKS and the inner side surface 70K are liquid-repellent, then the gap formed by the inner side surface 70K and the side surface PKS is prevented from any inflow of the liquid LQ1 of the first space K1, and the gas in the gap is prevented from being mixed as the bubble into the liquid LQ1 of the first space K1.

A seal member such as an O-ring and/or a V-ring may be arranged between the side surface 2FK of the optical element 2F and the inner side surface PKL of the barrel PK. A seal member such as an O-ring and/or a V-ring may be arranged between the side surface PKS of the barrel PK and the inner side surface 70K of the nozzle member 70.

Next, an explanation will be made about a method for exposing the substrate P with the image of the pattern of the mask M by using the exposure apparatus EX constructed as described above.

When the substrate P is exposed, the control unit CONT supplies the liquid LQ2 from the second liquid supply mechanism 30 to the second space K2. The control unit CONT supplies and recovers the liquid LQ2 by using the second liquid supply mechanism 30 and the second liquid recovery mechanism 60 while optimally controlling the supply amount of the liquid LQ2 per unit time brought about by the second liquid supply mechanism 30 and the recovery amount of the liquid LQ2 per unit time brought about by the second liquid recovery mechanism 60. At least the optical path for the exposure light beam EL, which is included in the second space K2, is filled with the liquid LQ2. When the supply of the liquid LQ2 to the second space K2 is started, it is also preferable that the supply amount of the liquid LQ2 per unit time, which is brought about by the second liquid supply mechanism 30, is gradually increased in order to suppress the inflow of the liquid LQ2 into the gap between the inner side surface PKL of the barrel PK and the side surface 2FK of the optical element 2F.

After the substrate P is loaded on the substrate stage PST at a load position, the substrate stage PST, which holds the substrate P, is moved by the control unit CONT to the position under the projection optical system PL, i.e., the exposure position. The control unit CONT supplies and recovers the liquid LQ1 by using the first liquid supply mechanism 10 and the first liquid recovery mechanism 20 while optimally controlling the supply amount of the liquid LQ1 per unit time brought about by the first liquid supply mechanism 10 and the recovery amount of the liquid LQ1 per unit time brought about by the first liquid recovery mechanism 20 in the state in which the substrate stage PST is opposed to the last optical element 2G of the projection optical system PL. The control unit CONT forms the liquid immersion area AR2 of the liquid LQ1 on at least the optical path for the exposure light beam EL included in the first space K1, and fills the optical path for the exposure light beam EL with the liquid LQ1.

In this arrangement, reference members (measuring members), which are provided with reference marks to be measured, for example, by a substrate alignment system as disclosed in Japanese Patent Application Laid-open No. 4-65603 and a mask alignment system as disclosed in Japanese Patent Application Laid-open No. 7-176468, are provided at predetermined positions on the substrate stage PST. Further, for example, an uneven illuminance sensor as disclosed, for example, in Japanese Patent Application Laid-open No. 57-117238, a spatial image-measuring sensor as disclosed, for example, in Japanese Patent Application Laid-open No. 2002-14005, and a radiation amount sensor (illuminance sensor) as disclosed, for example, in Japanese Patent Application Laid-open No. 11-16816 are provided as optical measuring sections at predetermined positions on the substrate stage PST. Before the exposure process is performed for the substrate P, the control unit CONT performs the measurement of the marks on the reference members, various types of measuring operations by using the optical measuring sections, and the operation for detecting the mark on the substrate P by using the substrate alignment system. The control unit CONT performs the alignment process for the substrate P and the process for adjusting (calibrating) the image formation characteristic of the projection optical system PL on the basis of the measurement results. For example, when the measuring operation by using the optical measuring section is performed, the control unit CONT moves the substrate stage PST relatively with respect to the liquid immersion area AR2 of the liquid LQ1 by moving the substrate stage PST in the XY directions to arrange the liquid immersion area AR2 of the liquid LQ1 on the optical measuring section so that the measuring operation is performed in this state through the liquid LQ1 and the liquid LQ2. The various types of the measuring operations, by using the reference members and the optical measuring sections, may be performed before the substrate P as the exposure objective is loaded on the substrate stage PST. The detection of the alignment mark on the substrate P, which is to be performed by the substrate alignment system, may be formed before the liquid immersion area AR2 of the liquid LQ1 is formed on the image plane side of the projection optical system PL.

After the alignment process and the calibration process are performed as described above, the control unit CONT projects the image of the pattern of the mask M onto the substrate P to perform the exposure via the projection optical system PL, the liquid LQ2 in the second space K2, and the liquid LQ1 in the first space K1 (i.e., the liquid of the liquid immersion area AR2), while moving, in the X axis direction (scanning direction), the substrate stage PST which supports the substrate P, while performing the recovery of the liquid LQ1 from the surface of the substrate P by using the first liquid recovery mechanism 20 concurrently with the supply of the liquid LQ1 onto the substrate P by using the first liquid supply mechanism 10.

The exposure apparatus EX of this embodiment performs the projection exposure onto the substrate P with the image of the pattern of the mask M while moving the mask M and the substrate P in the X axis direction (scanning direction). During the scanning exposure, a part of the image of the pattern of the mask M is projected into the projection area AR1 via the projection optical system PL and the liquid LQ1, LQ2 in the first and second spaces K1, K2. The mask M is moved at the velocity V in the -X direction (or in the +X direction), in synchronization with which the substrate P is moved at the velocity $\beta \cdot V$ ($\beta$ represents the projection magnification) in the +X direction (or in the -X direction) with respect to the projection area AR1. A plurality of shot areas are set on the substrate P. After the exposure is completed for one shot area, the next shot area is moved to the scanning start position in accordance with the stepping movement of the substrate P. The scanning exposure process is successively performed thereafter for the respective shot areas while moving the substrate P in the step-and-scan manner.

In this embodiment, the last optical element 2G, which is formed of the parallel flat plate, is arranged under the optical element 2F having the lens function. However, the first and second spaces K1, K2, which are disposed on the side of the lower surface 2S and on the side of the upper surface 2T of the last optical element 2G, are filled with the liquid LQ1, LQ2 respectively. Accordingly, the reflection loss is reduced on the lower surface 2U of the optical element 2F and the upper surface 2T of the last optical element 2G. The substrate P can be exposed satisfactorily in the state in which the large image side numerical aperture of the projection optical system PL is secured.

The supply and the recovery of the liquid LQ2, which are performed by the second liquid supply mechanism 30 and the second liquid recovery mechanism 60, are also continued during the exposure for the substrate P. Further, the supply and the recovery of the liquid LQ2, which are performed by the second liquid supply mechanism 30 and the second liquid recovery mechanism 60, are also continued before and after the exposure for the substrate P. When the supply and the recovery of the liquid LQ2, which are performed by the second liquid supply mechanism 30 and the second liquid recovery mechanism 60, are continued, the liquid LQ2 in the second space K2 is always exchanged with the flesh (clean) liquid LQ2. The exposure may be performed in a state in which the liquid LQ2 is allowed to remain in the second space K2 without performing the supply and the recovery of the liquid LQ2 with respect to the second space K2. However, there is such a possibility that the temperature of the liquid LQ2 may be changed due to the radiation of the exposure light beam EL, and the image formation characteristic of the projection optical system PL, which is to be obtained via the liquid, may be varied. Therefore, the temperature change of the liquid LQ2 in the second space K2 can be suppressed by always supplying the temperature-adjusted liquid LQ2 from the second liquid supply mechanism 30 and recovering the liquid LQ2 by the second liquid recovery mechanism 60. Similarly, the liquid LQ1 in the first space K1 is always exchanged with the fresh (clean) liquid LQ1 by always performing the supply and the recovery of the liquid LQ1 by the first liquid supply mechanism 10 and the first liquid recovery mechanism 20 during the radiation of the exposure light beam EL. It is possible to suppress the temperature change of the liquid LQ1 in the first space K1 (i.e., the liquid LQ1 in the liquid immersion area AR2 on the substrate P). When the supply and the recovery of the liquid LQ1, LQ2 are always performed to allow the fresh liquid LQ1, LQ2 to flow continuously, it is also possible to avoid the occurrence of the inconvenience which would be otherwise caused such that microbes (bacteria or the like) grow in the first and second spaces K1, K2, which would in turn deteriorate the cleanness.

The exposure may be performed in the state in which the liquid LQ2 is allowed to remain in the second space K2, and the liquid LQ2 in the second space K2 may be exchanged at every predetermined time intervals or every time when a predetermined number of substrates are processed, provided that the influence is to such an extent that the exposure accuracy is not affected by the temperature change or the like of the liquid LQ2 in the second space K2. In this procedure, the supply and the recovery of the liquid LQ2, which are to be performed by the second liquid supply mechanism 30 and the second liquid recovery mechanism 60, are stopped during the radiation of the exposure light beam EL (for example, during the exposure for the substrate P). Therefore, the vibration and the displacement of the optical element 2F, which would be otherwise caused by the supply of the liquid LQ2 (flow of the liquid LQ2), are avoided. It is possible to accurately execute the exposure for the substrate P and the various types of the measuring operations based on the use of the optical measuring sections as described above.

When the exposure for the substrate P is completed, then the control unit CONT stops the supply of the liquid LQ1 having been performed by the first liquid supply mechanism 10, and all of the liquid LQ1 in the liquid immersion area AR2 (liquid LQ1 in the first space K1) is recovered by using, for example, the first liquid recovery mechanism 20. Further, the control unit CONT recovers, for example, droplets of the liquid LQ1 remaining on the substrate P and on the substrate stage PST, by using, for example, the first recovery port 22 of the first liquid recovery mechanism 20. On the other hand, the control unit CONT continues the supply and the recovery of the liquid LQ2 by the second liquid supply mechanism 30 and the second liquid recovery mechanism 60 even after the completion of the exposure for the substrate P so to that the liquid LQ2 is allowed to continuously flow through the second space K2. Accordingly, it is possible to avoid the occurrence of the inconvenience which would be otherwise caused, for example, such that the cleanness of the second space K2 is deteriorated in the same manner as described above, and/or any adhesion trace (so-called water mark) is formed, for example, on the liquid contact surfaces 2U, 2T of the optical elements 2F, 2G due to the vaporization (drying) of the liquid LQ2. After the liquid LQ1 on the substrate P is recovered, the substrate stage PST, which supports the substrate P, is moved to the unload position by the control unit CONT to unload the substrate P. When the substrate stage PST is moved to the position (for example, the load position or the unload position) separated from the projection optical system PL, a predetermined member having a flat surface may be arranged on the image plane side of the projection optical system PL to continuously fill the space (first space) between the predetermined member and the projection optical system PL with the liquid LQ1.

There is such a possibility that the liquid LQ1 may be contaminated by being mixed, for example, with any impurity generated from the substrate P, including, for example, any foreign matter resulting, for example, from the photosensitive agent (photoresist), into the liquid LQ1 in the liquid immersion area AR2 (first space K1). There is such a possibility that the lower surface 2S of the last optical element 2G may be polluted with the contaminated liquid LQ1, because the liquid LQ1 in the liquid immersion area AR2 also makes contact with the lower surface 2S of the last optical element 2G. Further, there is also such a possibility that any impurity floating in the air may adhere to the lower surface 2S of the last optical element 2G exposed on the image plane side of the projection optical system PL.

In this embodiment, the last optical element 2G can be easily attached and detached (exchangeable) with respect to the barrel PK. Therefore, the deterioration of the exposure accuracy and the measurement accuracy via the projection optical system PL, which would be otherwise caused by the pollution of the optical element, can be avoided by exchanging only the polluted last optical element 2G with the clean last optical element 2G. On the other hand, the clean liquid LQ2 is always allowed to flow through the second space K2 continuously, and the liquid LQ2 in the second space K2 does not make any contact with the substrate P. Further, the second space K2 is the substantially closed space surrounded by the optical elements 2F, 2G and the barrel PK. Therefore, the impurity floating in the air is hardly mixed into the liquid LQ2 in the second space K2, and the impurity hardly adheres to the optical element 2F. Therefore, the cleanness is maintained for the lower surface 2U of the optical element 2F and the upper surface 2T of the last optical element 2G. Therefore, when only the last optical element 2G is exchanged, then it is possible to avoid, for example, the deterioration of the transmittance of the projection optical system PL, and it is possible to maintain the exposure accuracy and the measurement accuracy.

As explained above, the first space K1 disposed on the side of the lower surface 2T of the last optical element 2G and the second space K2 disposed on the side of the upper surface 2S of the last optical element 2G are the independent spaces, and the first space K1 and the second space K2 are filled with the liquid LQ1, LQ2 respectively to perform the exposure. Accordingly, the exposure light beam EL, which has passed through the mask M, is successfully allowed to arrive at the substrate P in a well-suited manner via the part of the lower surface 2U of the optical element 2F, the part of the upper surface 2T of the last optical element 2G, and the part of the lower surface 2S of the last optical element 2G.

The last optical element 2G, which has the high possibility of being polluted, is easily exchangeable, and thus the exposure can be performed satisfactorily by using the projection optical system PL provided with the clean last optical element 2G. An arrangement is also conceived, in which the liquid of the liquid immersion area AR2 is allowed to make contact with the optical element 2F without providing the last optical element 2G formed of the parallel flat plate. However, if it is intended to increase the image side numerical aperture of the projection optical system PL, then it is necessary to increase the effective diameter of the optical element, and it is inevitable that the optical element 2F has a large size. The nozzle member 70 as described above and the various types of the measuring units such as the alignment system (not shown) are arranged around the optical element 2F. Therefore, if such a large-sized optical element 2F is exchanged, then the operability is lowered, and the operation is difficult to be performed. Further, the optical element 2F has the refractive index (lens function). Therefore, it is necessary that the optical element 2F should be attached to the barrel PK with the high positioning accuracy in order to maintain the optical characteristic (image formation characteristic) of the entire projection optical system PL. This embodiment is constructed such that the relatively small-sized parallel flat plate is provided as the last optical element 2G, and the last optical element 2G is exchanged. Therefore, the operability is satisfactory, and the exchange operation can be performed with ease. It is also possible to maintain the optical characteristic of the projection optical system PL. Further, the exposure apparatus EX is provided with the first and second liquid supply mechanisms 10, 30 and the first and second liquid recovery mechanisms 20, 60 which are capable of independently supplying and recovering the liquid LQ1, LQ2 with respect to the first space K1 disposed on the side of the lower surface 2S of the last optical element 2G and the second space K2 disposed on the side of the upper surface 2T respectively. Accordingly, the exposure light beam EL, which is radiated from the illumination optical system IL, is successfully made to satisfactorily arrive at the substrate P arranged on the image plane side of the projection optical system PL while maintaining the cleanness of the liquid LQ1, LQ2.

In this embodiment, the second space K2 is filled with the liquid LQ2 so that the substantially entire areas of the lower surface 2U of the optical element 2F and the upper surface 2T of the last optical element 2G are wetted respectively. However, it is enough that a part of the second space K2 is filled with the liquid LQ2 so that the liquid LQ2 is arranged on the optical path for the exposure light beam EL. In other words, it is enough that the necessary part of the second space K2 is sufficiently filled with the liquid LQ2. Similarly, it is enough that the necessary part of the first space K1 is sufficiently filled with the liquid LQ1 as well.

In the embodiment explained with reference to Figs. 1 to 3, the mechanism, which is provided to locally form the liquid immersion area AR2 on the substrate P, is not limited to the first liquid supply mechanism 10 and the first liquid recovery mechanism 20 (nozzle member 70). It is possible to use various types of mechanisms. For example, it is also possible to use mechanisms as disclosed in European Patent Publication No. EP 1420298 (A2) and United States Patent Publication No. 2004/0207824, contents of which are incorporated herein by reference within a range of permission of the domestic laws and ordinances of the state designated or selected in this international application.


Second Embodiment

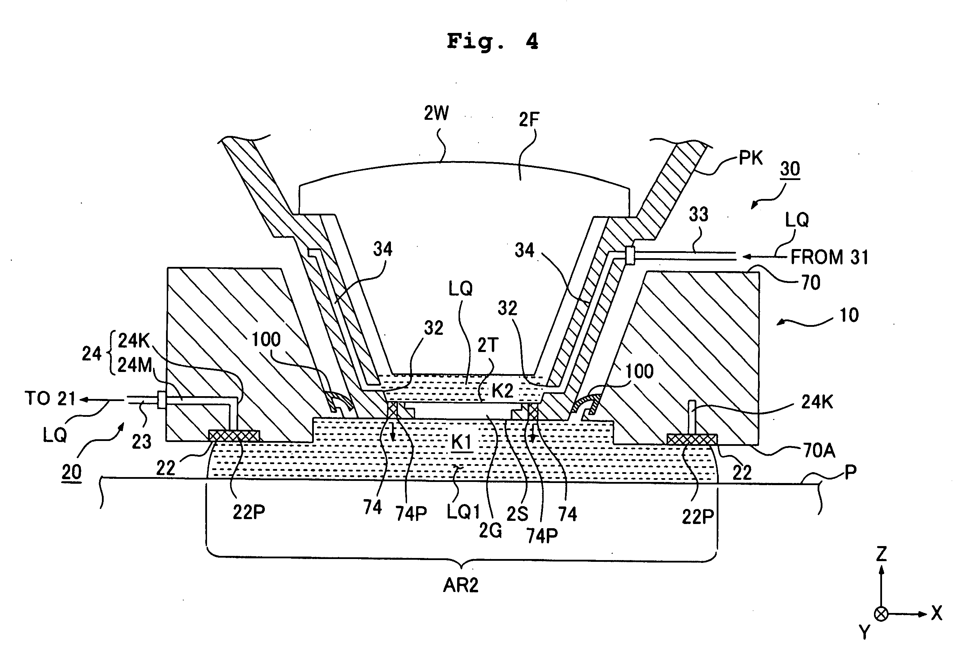

Next, a second embodiment of the present invention will be explained with reference to Fig. 4. In the following description, the constitutive components, which are the same as or equivalent to those of the embodiment described above, are designated by the same reference numerals, any explanation of which will be simplified or omitted.

The characteristic feature of this embodiment is that connecting holes 74, which connect the first space K1 and the second space K2, are provided. The plurality of connecting holes 74 are provided at predetermined intervals in the circumferential direction on the lower surface of the barrel PK. A porous material 74P is provided in each of the connecting holes 74.

In this embodiment, the first liquid supply mechanism (10), which includes the first supply port for directly supplying the liquid to the first space K1, is not provided. Further, the second liquid recovery mechanism (60), which directly recovers the liquid from the second space K2, is not provided as well. An exposure apparatus EX of this embodiment is provided with the second liquid supply mechanism 30 which supplies the liquid LQ to the second space K2, and the first liquid recovery mechanism 20 which recovers the liquid LQ from the first space K1 (liquid immersion area AR2).

In this embodiment, a seal member 100 is provided to avoid any inflow of the liquid LQ of the first space K1 into the gap between the nozzle member 70 and the side surface of the barrel PK. It is desirable that the seal member 100 is formed of a flexible member of, for example, rubber or silicon in view of the prevention of transmission of the vibration of the nozzle member 70 to the barrel PK. It is also allowable that the seal member 100 is not provided. As described in the first embodiment, for example, when the side surface of the barrel PK and the inner side surface 70K of the nozzle member 70 are made liquid-repellent, it is possible to avoid the inflow of the liquid LQ of the first space K1 into the gap and the inflow of the gas into the liquid LQ of the first space K1.

When the first space K1 and the second space K2 are filled with the liquid LQ, the control unit CONT supplies the liquid LQ to the second space K2 by using the second liquid supply mechanism 30. The liquid LQ, which has been supplied to the second space K2, is also supplied to the first space K1 via the connecting holes 74. The second liquid supply mechanism 30 supplies the liquid LQ from the second space K2, and makes the liquid LQ to flow into the first space K1 via the connecting holes 74 as well. Accordingly, the first space K1 and the second space K2 are filled with the liquid LQ. The liquid LQ, which is supplied to the first space K1 via the connecting holes 74, forms the liquid immersion area AR2 on the substrate P. The liquid LQ of the liquid immersion area AR2 is recovered from the first recovery port 22 of the first liquid supply mechanism 20. After the first space K1 and the second space K2 are filled with the liquid LQ, the control unit CONT radiates the exposure light beam EL onto the substrate P through the liquid LQ in the first space K1 and the second space K2 to expose the substrate P. In this embodiment, the first liquid supply mechanism 10 may be used in combination to supply the liquid LQ to the first space K1.

As described above, the structure of the apparatus can be simplified by connecting the first space K1 and the second space K2 via the connecting holes 74.

The first space K1 and the second space K2 may be filled with the liquid LQ such that the first space K1 is filled with the liquid LQ, and then the liquid LQ, with which the first space K1 is filled, is allowed to flow into the second space K2 via the connecting holes 74. In this case, the second space K2 is filled with the liquid LQ which has made contact with the substrate P. Therefore, for example, when chemical filters or the like are arranged beforehand in the connecting holes 74, the second space K2 is not filled with the liquid LQ contaminated with any impurity generated, for example, from the surface of the substrate P.

Third Embodiment

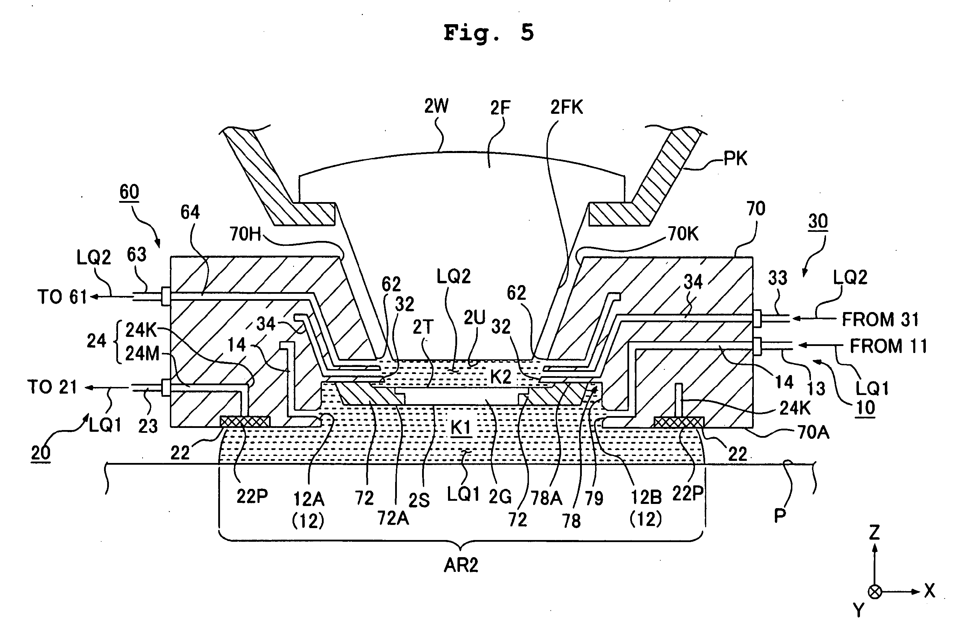

Next, a third embodiment of the present invention will be explained with reference to Fig. 5.

The characteristic feature of this embodiment is that the last optical element 2G is supported by a nozzle member 70. In other words, the characteristic feature is that the last optical element 2G is supported separately from the other optical elements 2A to 2F for constructing the projection optical system PL.

With reference to Fig. 5, the optical element 2F is exposed from the barrel PK. The optical elements 2A to 2F, which are included in the plurality of optical elements 2A to 2G for constructing the projection optical system PL, are supported by the barrel PK. On the other hand, the last optical element 2G is supported by the nozzle member 70 by the aid of a connecting member 72. The nozzle member 70, which is an annular member, is arranged in the vicinity of the optical elements 2F, 2G disposed at the end portion of the projection optical system PL. The nozzle member 70 is provided to surround the optical elements 2F, 2G over the substrate P (substrate stage PST). That is, the optical elements 2F, 2G are arranged inside of the hole 70H of the nozzle member 70. The hole 70H is formed inside of the recess 78.

The last optical element 2G is held by the cavity surface 78A of the nozzle member 70 via the connecting member 72. The connecting member 72 is fixed to the cavity surface 78A of the nozzle member 70. The last optical element 2G is fixed to the connecting member 72. The last optical element 2G, which is held by the nozzle member 70 via the connecting member 72, is separated from the optical elements 2A to 2F which are held by the barrel PK. The second space K2 is formed between the upper surface 2T of the last optical element 2G and the lower surface 2U of the optical element 2F. In this arrangement, the last optical element 2G is supported by the nozzle member 70 via the connecting member 72 in a state in which the last optical element 2G is separated from the other optical elements 2A to 2F held by the barrel PK.

The lower surface 72A of the connecting member 72 is substantially flush with the lower surface 2S of the last optical element 2G formed of the parallel flat plate and held by the connecting member 72. The upper surface 2T and the lower surface 2S of the last optical element 2G supported by the connecting member 72 are substantially in parallel to the XY plane. Further, the connecting portion between the connecting member 72 and the cavity surface 78A and the connecting portion between the last optical element 2G and the connecting member 72, or the like, are sealed. The connecting member 72 is a substantially plate-shaped member in which any hole or the like is not provided. That is, the first space K1 disposed on the side of the lower surface 2S of the last optical element 2G and the second space K2 disposed on the side of the upper surface 2T are mutually independent spaces. The flow or communication of the liquid is prohibited between the first space K1 and the second space K2.

The last optical element 2G can be easily attached and detached with respect to the connecting member 72. That is, the last optical element 2G is provided exchangeably. In order to exchange the last optical element 2G, the connecting member 72 may be attachable/detachable (exchangeable) with respect to the nozzle member 70 (cavity surface 78A). Alternatively, the nozzle member 70 may be exchangeable.

The first supply ports 12 (12A, 12B), which construct parts of the first liquid supply mechanism 10, are provided on the inner side surface 79 which is disposed inside the recess 78 and which is included in the lower surface 70A of the nozzle member 70, in the same manner as in the first embodiment. The first recovery port 22, which constructs a part of the first liquid recovery mechanism 20, is provided outside the recess 78 with reference to the projection area AR1 of the projection optical system PL on the lower surface 70A of the nozzle member 70, in the same manner as in the first embodiment.

The nozzle member 70, which is supported by the lower step 8 of the main column 1 via the connecting member 52, is separated from the projection optical system PL (optical element 2F). That is, a gap is provided between the inner side surface 70K of the hole 70H of the nozzle member 70 and the side surface 2FK of the optical element 2F. A gap is also provided between the nozzle member 70 and the barrel PK which holds the optical element 2F. The gaps are provided in order to isolate the projection optical system PL (optical elements 2A to 2F) from the nozzle member 70 in terms of the vibration. Accordingly, the vibration, which is generated in the nozzle member 70, is prevented from being transmitted to the projection optical system PL. As described above, the main column 1 (lower step 8) and the barrel surface plate 5 are isolated from each other in terms of the vibration by the aid of the anti-vibration unit 47. Therefore, the vibration, which is generated in the nozzle member 70, is prevented from being transmitted to the projection optical system PL via the main column 1 and the barrel surface plate 5.

Second supply ports 32, which construct parts of the second liquid supply mechanism 30, are provided on the inner side surface 70K of the nozzle member 70. The liquid LQ2, which is fed from the second liquid supply section 31, flows through the second supply ports 32 substantially in parallel to the upper surface 2T of the last optical element 2G, i.e., substantially in parallel to the XY plane (in the lateral direction). The force, which is exerted by the supplied liquid LQ2, for example, on the optical element 2G, can be reduced, because the second supply ports 32 discharge the liquid LQ2 substantially in parallel to the upper surface 2T of the last optical element 2G. Therefore, it is possible to avoid the occurrence of the inconvenience which would be otherwise caused, for example, such that the optical element 2G, the connecting member 72, and/or the optical element 2F is deformed and/or displaced due to the supply of the liquid LQ2.

Second recovery ports 62, which construct parts of the second liquid recovery mechanism 60, are provided at predetermined positions with respect to the second supply ports 32 on the inner side surface 70K of the nozzle member 70. In this embodiment, the second recovery ports 62 are provided above the second supply ports 32.

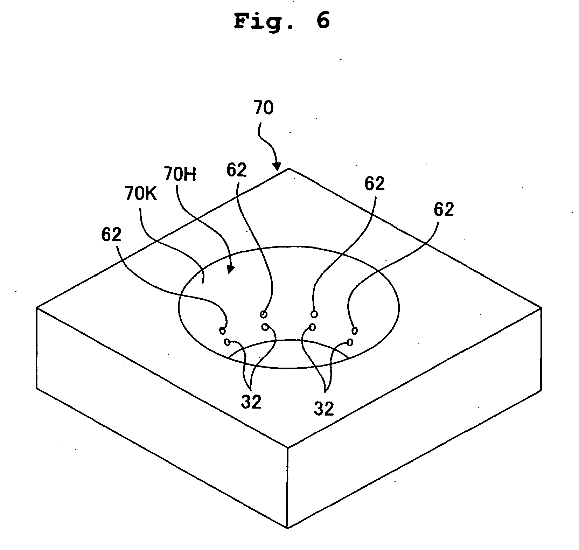

Fig. 6 shows a schematic perspective view illustrating the nozzle member 70. As shown in Fig. 6, the plurality of second supply ports 32 are provided on the inner side surface 70K of the nozzle member 70. In this embodiment, the second supply ports 32 are provided at substantially equal intervals in the circumferential direction on the inner side surface 70K. Similarly, the plurality of second recovery ports 62 are provided on the inner side surface 70K of the nozzle member 70. In this embodiment, the second recovery ports 62 are provided at substantially equal intervals in the circumferential direction over the second supply ports 32.

In Fig. 6, the second supply ports 32 and the second recovery ports 62 are formed to be substantially circular. However, the second supply ports 32 and the second recovery ports 62 may be formed to have arbitrary shapes including, for example, elliptical, rectangular, and slit shapes. In this embodiment, the second supply ports 32 and the second recovery ports 62 mutually have approximately the same size respectively. However, the second supply ports 32 and the second recovery ports 62 may have mutually different sizes. The second supply ports 32 may be arranged over the second recovery ports 62. Further, any arrangement may be arbitrarily set, for example, such that the second supply ports 32 are provided on the +X side and the second recovery ports 62 are provided on the -X side on the inner side surface 70K with the optical axis AX of the projection optical system PL intervening therebetween, in addition to the arrangement in which the second supply ports 32 and the second recovery ports 62 are provided and aligned in the circumferential direction on the inner side surface 70K respectively. That is, for example, the numbers, the arrangement, and the shapes of the second supply ports 32 and the second recovery ports 62 are not limited to those of the structure shown in Figs. 5 and 6 in this embodiment as well. Any structure may be employed provided that the optical path for the exposure light beam EL between the optical element 2F and the optical element 2G is filled with the second liquid LQ2.

The second supply ports 32 and the second recovery ports 62 may be formed in the arrangement as shown in Fig. 6 on the inner side surface PKL of the barrel PK in the embodiment explained with reference to Fig. 2.

As shown in Fig. 5, the other end of the supply tube 33 is connected to one end of the second supply flow passage 34 formed in the nozzle member 70. On the other hand, the other end of the second supply flow passage 34 of the nozzle member 70 is connected to the second supply ports 32 formed on the inner side surface 70K of the nozzle member 70. In this arrangement, the second supply flow passage 34, which is formed in the nozzle member 70, is branched at an intermediate position so that the other ends can be connected to the plurality of second supply ports 32 respectively. The second supply ports 32 may be formed to be funnel-shaped or trumpet-shaped in the same manner as the first supply port 12 described above.

The operation of the second liquid supply section 31 for supplying the liquid is controlled by the control unit CONT. When the control unit CONT feeds the liquid LQ2 from the second liquid supply section 31 of the second liquid supply mechanism 30, then the liquid LQ2, which is fed from the second liquid supply section 31, flows through the supply tube 33, and then the liquid LQ2 flows into one end of the second supply flow passage 34 formed in the nozzle member 70. The liquid LQ2, which has flown into one end of the second supply flow passage 34, is branched at the intermediate position into the plurality of flows, and then the liquid LQ2 is supplied to the second space K2 between the optical element 2F and the last optical element 2G from the plurality of second supply ports 32 formed on the inner side surface 70K of the nozzle member 70.

As shown in Fig. 5, the other end of the recovery tube 63 is connected to one end of the second recovery flow passage 64 formed in the nozzle member 70. On the other hand, the other ends of the second recovery flow passage 64 are connected to the second recovery ports 62 formed on the inner side surface 70K of the nozzle member 70. In this arrangement, the second recovery flow passage 64, which is formed in the nozzle member 70, is branched at an intermediate position so that the other ends can be connected to the plurality of second recovery ports 62 respectively.

The operation of the second liquid recovery section 61 for recovering the liquid is controlled by the control unit CONT. The control unit CONT drives the second liquid recovery section 61 of the second liquid recovery mechanism 60 in order to recover the liquid LQ2. When the second liquid recovery section 61 having the vacuum system is driven, then the liquid LQ2 in the second space K2 flows into the second recovery flow passage 64 via the second recovery ports 62, and then the liquid LQ2 is sucked and recovered by the second liquid recovery section 61 via the recovery tube 63.

In this embodiment, each of the inner side surface 70K of the nozzle member 70 and the side surface 2FK of the optical element 2F is subjected to the liquid-repelling treatment to have the liquid-repelling property. When the inner side surface 70K of the nozzle member 70 and the side surface 2FK of the optical element 2F are allowed to have the liquid-repelling property, then it is possible to avoid the inflow of the liquid LQ2 of the second space K2 into the gap formed by the inner side surface 70K and the side surface 2FK, and the gas in the gap is prevented from being mixed as the bubble into the liquid LQ2 in the second space K2.

As described above, the last optical element 2G and the other optical elements 2A to 2F are supported separately from each other. The first space K1 disposed on the side of the lower surface 2T of the last optical element 2G and the second space K2 disposed on the side of the upper surface 2S of the last optical element 2G are the independent spaces. The first space K1 and the second space K2 are filled with the liquid LQ1, LQ2 respectively to perform the exposure. Accordingly, the exposure light beam EL, which has passed through the mask M, is successfully allowed to arrive at the substrate P satisfactorily.

When the last optical element 2G is supported by the nozzle member 70, it is possible to provide the arrangement in which the barrel PK is not arranged between the optical elements 2F, 2G and the nozzle member 70. Therefore, the nozzle member 70 can be disposed closely to the optical elements 2F, 2G. It is possible to improve the degree of freedom of the apparatus design, for example, such that the apparatus can be made compact. Further, the first supply ports 12 and the first recovery port 22, which are formed for the nozzle member 70, can be disposed closely to the projection area AR1. Accordingly, it is possible to decrease the size of the liquid immersion area AR2. Therefore, it is unnecessary to provide any large-sized substrate stage PST depending on the size of the liquid immersion area AR2, and it is unnecessary to increase the movement stroke of the substrate stage PST. Accordingly, the apparatus can be made compact.

The nozzle member 70 is the member which has the supply ports 12 and the recovery port 22 for supplying and recovering the liquid with respect to the liquid immersion area AR2 (first space K1). The nozzle member 70 undergoes the shearing force of the liquid in the liquid immersion area AR2 in accordance with the movement of the substrate P (substrate stage PST). Therefore, the vibration tends to appear on the nozzle member 70. However, in this embodiment, the optical element 2G supported by the nozzle member 70 is the parallel flat plate. Therefore, it is possible to suppress the influence of the vibration of the nozzle member 70 exerted on the accuracy of the exposure and the measurement. On the other hand, as described above, the vibration hardly appears on the barrel PK, for example, by the aid of the anti-vibration unit 47. Therefore, it is possible to suppress the influence exerted on the image formation characteristic of the projection optical system PL by supporting the last optical element 2G with the barrel PK as in the first and second embodiments explained with reference to Figs. 2 and 5.

When the last optical element 2G is supported by the nozzle member 70, the vibration, which is generated in the nozzle member 70, can be prevented from being transmitted to the last optical element 2G by providing a anti-vibration mechanism between the nozzle member 70 and the last optical element 2G. Also in this embodiment, the supply and the recovery of the liquid LQ2, which are to be performed by the second liquid supply mechanism 30 and the second liquid recovery mechanism 60, are continued to continuously fill the second space K2 with the liquid LQ2 during the period in which the exposure light beam EL is emitted, in the same manner as in the first embodiment. Accordingly, it is possible to suppress the deterioration of cleanness and the temperature change of the liquid LQ2 of the second space K2 in the same manner as described above. On the other hand, the supply and the recovery of the liquid LQ2, which are to be performed by the second liquid supply mechanism 30 and the second liquid recovery mechanism 60, may be stopped in the state in which the second space K2 is filled with the liquid LQ2 during the period in which the exposure light beam EL is emitted. Accordingly, it is possible to avoid the vibration and the displacement of the optical element 2F which would be otherwise caused by the supply of the liquid LQ2 (flow of the liquid LQ2). It is possible to accurately execute the exposure for the substrate P and the various types of the measuring operations based on the use of the optical measuring sections as described above.

Fourth Embodiment

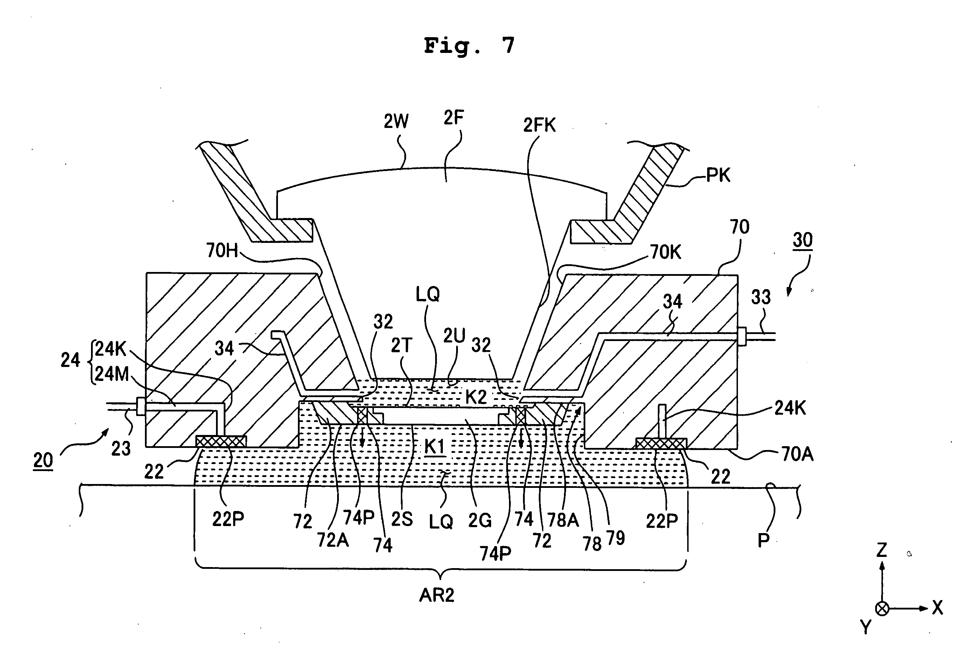

Next, a fourth embodiment of the present invention will be explained with reference to Fig. 7. The characteristic feature of this embodiment is that connecting holes 74, which connect the first space K1 and the second space K2, are provided for a connecting member 72. The connecting member 72 has the plurality of connecting holes 74 which are provided at predetermined intervals in the circumferential direction. A porous material 74P is provided in each of the connecting holes 74.

In this embodiment, the first liquid supply mechanism (10), which includes the first supply port for directly supplying the liquid to the first space K1, is not provided. Further, the second liquid recovery mechanism (60), which directly recovers the liquid from the second space K2, is not provided as well. On the other hand, an exposure apparatus EX of this embodiment is provided with the second liquid supply mechanism 30 which supplies the liquid LQ to the second space K2, and the first liquid recovery mechanism 20 which recovers the liquid LQ from the first space K1 (liquid immersion area AR2).

When the first space K1 and the second space K2 are to be filled with the liquid LQ, the control unit CONT supplies the liquid LQ to the second space K2 by using the second liquid supply mechanism 30. The liquid LQ, which has been supplied to the second space K2, is also supplied to the first space K1 via the connecting holes 74. In this way, the second liquid supply mechanism 30 supplies the liquid LQ from the second space K2, and the liquid LQ is allowed to flow into the first space K1 via the connecting holes 74 as well. Accordingly, the first space K1 and the second space K2 are filled with the liquid LQ. The liquid LQ, which is supplied to the first space K1 via the connecting holes 74, forms the liquid immersion area AR2 on the substrate P. The liquid LQ of the liquid immersion area AR2 is recovered from the first recovery port 22 of the first liquid supply mechanism 20. After the first space K1 and the second space K2 are filled with the liquid LQ, the control unit CONT radiates the exposure light beam EL onto the substrate P through the liquid LQ in the first space K1 and the second space K2 to expose the substrate P.

As described above, the structure of the apparatus can be simplified by connecting the first space K1 and the second space K2 via the connecting holes 74. Also in this embodiment, the first space K1 and the second space K2 may be filled with the liquid LQ such that the first space K1 is filled with the liquid LQ, and then the liquid LQ, with which the first space K1 is filled, is made to flow into the second space K2 via the connecting holes 74.

In the third and fourth embodiments described above, the last optical element 2G is supported by the nozzle member 70 having the liquid flow passages for the first space K1 and the second space K2. However, the last optical element 2G may be supported by a nozzle member 70 having a liquid flow passage provided for any one of the first space K1 and the second space K2. The last optical element 2G may be supported by a nozzle member having only a supply port for supplying the liquid to at least one of the first space K1 and the second space K2. Alternatively, the last optical element 2G may be supported by a nozzle member having only a recovery port for recovering the liquid from at least one of the first space K1 and the second space K2. In the third and fourth embodiments described above, the last optical element 2G is supported by the nozzle member 70. However, there is no limitation thereto. The last optical element 2G may be supported by a member which is different from the nozzle member 70 and the barrel PK.

The arrangement, in which the last optical element 2G is supported by the nozzle member 70 as adopted in the third and fourth embodiments described above, can be also adopted for a liquid immersion exposure system in which only the first space K1 is filled with the liquid.

In the first to fourth embodiments described above, the projection optical system PL is adjusted to have the predetermined image formation characteristic also for the last optical element 2G which is the parallel flat plate having no refractive power. However, when the last optical element 2G does not exert any influence on the image formation characteristic at all, the adjustment may be made such that the image formation characteristic of the projection optical system PL is the predetermined image formation characteristic except for the last optical element 2G.

In the first to fourth embodiments described above, the last optical element 2G is the parallel flat plate having no refractive power. However, the last optical element 2G may be an optical element having any refractive power. That is, the upper surface 2T of the last optical element 2G has any curvature. In this case, in order to exchange the last optical element 2G with ease, it is desirable that the curvature of the upper surface 2T of the last optical element 2G is as small as possible.

In the first to fourth embodiments described above, the liquid LQ1 in the first space K1 is thicker than the liquid LQ2 in the second space K2 on the optical axis AX of the projection optical system PL. However, the liquid LQ2 in the second space K2 may be thicker than the liquid LQ1 in the first space K1. Alternatively, the liquid LQ2 in the second space K2 and the liquid LQ1 in the first space K1 may have the same thickness. Further, in the first to fourth embodiments described above, the thickness of the last optical element 2G is thinner than those of the liquid LQ1 in the first space K1 and the liquid LQ2 in the second space K2 in relation to the Z axis direction. However, the last optical element 2G may have the thickest thickness. That is, the thicknesses in the Z axis direction of the liquid LQ1 in the first space K1, the liquid LQ2 in the second space K2, and the last optical element 2G may be appropriately determined so that the image formation state of the pattern projected onto the substrate P via the liquid LQ1, LQ2 and the last optical element 2G is optimized. For example, each of the liquid LQ1 and the liquid LQ2 on the optical axis AX may have a thickness of not more than 5 mm, and the thickness of the last optical element 2G may be 3 to 12 mm.

In the first to fourth embodiments described above, the last optical element 2G is supported in the substantially stationary state with respect to the optical axis AX of the projection optical system PL. However, the last optical element 2G may be supported finely movably in order to adjust the position and the inclination thereof. For example, an actuator may be arranged at the support portion for the last optical element 2G to automatically adjust the position (in the X axis direction, the Y axis direction, and the Z axis direction) and the inclination (in the $\theta$X direction and the $\theta$Y direction) of the last optical element 2G. In this case, when the last optical element 2G is held by the nozzle member 70 as in the third and fourth embodiments, the position and/or the inclination of the last optical element 2G may be adjusted by adjusting the position and the inclination of the nozzle member.

In the first to fourth embodiments described above, the exposure apparatus may further include a measuring unit such as an interferometer for measuring the position (in the X axis direction, the Y axis direction, and the Z axis direction) and the inclination (in the $\theta$X direction and the $\theta$Y direction) of the last optical element 2G. It is desirable that the measuring unit can measure the position and the inclination with respect to the optical elements 2A to 2F. When the measuring unit as described above is provided, it is possible to easily know the deviation of the position and the inclination of the last optical element 2G. When the measuring unit is used in combination with the actuator as described above, it is possible to highly accurately adjust the position and the inclination of the last optical element 2G.

As described in the third and fourth embodiments, when the last optical element 2G is supported separately from the optical element 2F, the pressure and the vibration, which are received from the liquid LQ1 by the last optical element 2G, are not directly transmitted to the optical elements 2A to 2F. Therefore, it is possible to suppress the deterioration of the image formation characteristic of the projection optical system PL. In this case, when the last optical element 2G is held softly and/or when the position and/or the inclination of the last optical element 2G are adjusted depending on the inclination of the substrate P (inclination of the substrate stage PST), then it is possible to more effectively suppress the transmission of the pressure and the vibration to the optical elements 2A to 2F.

As described above, pure water is used as the liquid LQ1, LQ2 in the embodiment of the present invention. Pure water is advantageous in that pure water is available in a large amount with ease, for example, in the semiconductor production factory, and pure water exerts no harmful influence, for example, on the optical element (lens) and the photoresist on the substrate P. Further, pure water exerts no harmful influence on the environment, and the content of impurity is extremely low. Therefore, it is also expected to obtain the function to wash the surface of the substrate P and the surface of the optical element provided at the end surface of the projection optical system PL. When the purity of pure water supplied from the factory or the like is low, the exposure apparatus may have an ultrapure water-producing unit.

It is approved that the refractive index n of pure water (water) with respect to the exposure light beam EL having a wavelength of about 193 nm is approximately in an extent of 1.44. When the ArF excimer laser beam (wavelength: 193 nm) is used as the light source of the exposure light beam EL, then the wavelength is shortened on the substrate P by 1/n, i.e., to about 134 nm, and a high resolution is obtained. Further, the depth of focus is magnified about n times, i.e., about 1.44 times as compared with the value obtained in the air. Therefore, when it is enough to secure an approximately equivalent depth of focus as compared with the case of the use in the air, it is possible to further increase the numerical aperture of the projection optical system PL. Also in this viewpoint, the resolution is improved.

In the embodiments shown in Figs. 2 and 5 described above, the same pure water is supplied as the liquid LQ1, LQ2. However, the quality of pure water (liquid LQ1) supplied to the first space may be different from the quality of pure water (liquid LQ2) supplied to the second space. The quality of pure water includes, for example, the setting temperature, the temperature uniformity, the temperature stability, the specific resistance value, the TOC (total organic carbon) value, and the dissolved gas concentration (dissolved oxygen, dissolved nitrogen). For example, the quality of pure water supplied to the first space K1 close to the image plane of the projection optical system PL may be higher than the quality of pure water supplied to the second space K2. Mutually different types of liquids may be supplied to the first space and the second space, and the liquid LQ1, with which the first space K1 is filled, may be of the type different from that of the liquid LQ2 with which the second space K2 is filled. For example, it is possible to use those having mutually different refractive indexes and/or transmittances with respect to the exposure light beam EL. For example, the second space K2 may be filled with a predetermined liquid other than pure water, which is represented by fluorine-based oil or the like. The oil is such a liquid that the probability of proliferation of microbes such as bacterial is low. Therefore, it is possible to maintain the cleanness of the second space K2 and the flow passage through which the liquid LQ2 (fluorine-based oil) flows.

Both of the liquids LQ1, LQ2 may be liquids other than water. For example, when the light source of the exposure light beam EL is the $F_2$ laser, the $F_2$ laser beam is not transmitted through water. Therefore, it is preferable to use, as the liquid LQ1, LQ2, a fluorine-based liquid including, for example, perfluoropolyether (PFPE) and fluorine-based oil through which the $F_2$ laser beam is transmissive. In this case, the portion, which makes contact with the liquid LQ1, LQ2, is subjected to the liquid-attracting treatment, for example, by forming a thin film with a substance having a molecular structure with small polarity including fluorine. Alternatively, other than the above, it is also possible to use, as the liquid LQ1, LQ2, those (for example, cedar oil) which have the transmittance with respect to the exposure light beam EL, which have the refractive index as high as possible, and which are stable against the photoresist coated on the surface of the substrate P and the projection optical system PL. Also in this case, the surface treatment is applied depending on the polarity of the liquid LQ1, LQ2 to be used. It is also possible to use various types of fluids having desired refractive indexes, including, for example, supercritical fluids and gases having high refractive indexes, in place of pure water for the liquid LQ.

In the case of the liquid immersion method as described above, the numerical aperture NA of the projection optical system is 0.9 to 1.3 in some cases.

When the numerical aperture NA of the projection optical system is large as described above, it is desirable to use the polarized illumination, because the image formation performance is deteriorated due to the polarization effect in some cases with the random polarized light which has been hitherto used as the exposure light beam. In this case, it is appropriate that the linear polarized illumination, which is adjusted to the longitudinal direction of the line pattern of the line-and-space pattern of the mask (reticle), is effected so that the diffracted light of the S-polarized light component (TE-polarized light component), i.e., the component in the polarization direction along with the longitudinal direction of the line pattern is dominantly allowed to outgo from the pattern of the mask (reticle). When the space between the projection optical system PL and the resist coated on the surface of the substrate P is filled with the liquid, the diffracted light of the S-polarized light component (TE-polarized light component), which contributes to the improvement in the contrast, has the high transmittance on the resist surface, as compared with the case in which the space between the projection optical system PL and the resist coated on the surface of the substrate P is filled with the air (gas). Therefore, it is possible to obtain the high image formation performance even when the numerical aperture NA of the projection optical system exceeds 1.0. Further, it is more effective to appropriately combine, for example, the phase shift mask and the oblique incidence illumination method (especially the dipole illumination method) adjusted to the longitudinal direction of the line pattern as disclosed in Japanese Patent Application Laid-open No. 6-188169. In particular, the combination of the linear polarized illumination method and the dipole illumination method is effective when the direction of the cycle of the line-and-space pattern is limited to a predetermined certain direction and/or when the hole pattern is clustered in a predetermined certain direction. For example, when a phase shift mask of the half tone type having a transmittance of 6 % (pattern of a half pitch of about 45 nm) is illuminated by using the linear polarized illumination method and the dipole illumination method in combination, the depth of focus (DOF) can be increased by about 150 nm as compared with a case in which the random polarized light beam is used, provided that the illumination $\sigma$, which is defined by the circumscribed circle of the two light fluxes for forming the dipole at the pupil plane of the illumination system, is 0.95, the radius of each light flux at the pupil plane is $0.125\sigma$, and the numerical aperture of the projection optical system PL is NA = 1.2.

For example, when the ArF excimer laser is used as the exposure light beam, and the substrate P is exposed with a fine line-and-space pattern (for example, line-and-space of about 25 to 50 nm) by using the projection optical system PL having a reduction magnification of about 1/4, then the mask M acts as a polarizing plate due to the Wave guide effect depending on the structure of the mask M (for example, the pattern fineness and the thickness of chromium), and the diffracted light of the S-polarized light component (TE-polarized light component) is radiated from the mask M in an amount larger than that of the diffracted light of the P-polarized light component (TM-polarized light component) which lowers the contrast. In this case, it is desirable to use the linear polarized illumination as described above. However, even when the mask M is illuminated with the random polarized light, it is possible to obtain the high resolution performance even when the numerical aperture NA of the projection optical system PL is large, for example, 0.9 to 1.3.

When the substrate P is exposed with an extremely fine line-and-space pattern on the mask M, there is such a possibility that the P-polarized light component (TM-polarized light component) is larger than the S-polarized light component (TE-polarized light component) due to the Wire Grid effect. However, for example, when the ArF excimer laser is used as the exposure light beam, and the substrate P is exposed with a line-and-space pattern larger than 25 nm by using the projection optical system PL having a reduction magnification of about 1/4, then the diffracted light of the S-polarized light component (TE-polarized light component) is radiated from the mask M in an amount larger than that of the diffracted light of the P-polarized light component (TM-polarized light component). Therefore, it is possible to obtain the high resolution performance even when the numerical aperture NA of the projection optical system PL is large, for example, 0.9 to 1.3.

Further, it is also effective to use the combination of the oblique incidence illumination method and the polarized illumination method in which the linear polarization is effected in the tangential (circumferential) direction of the circle having the center of the optical axis as disclosed in Japanese Patent Application Laid-open No. 6-53120, as well as the linear polarized illumination (S-polarized illumination) adjusted to the longitudinal direction of the line pattern of the mask (reticle). In particular, when the pattern of the mask (reticle) includes not only the line pattern extending in one predetermined direction, but the pattern also includes the line patterns extending in a plurality of different directions in a mixed manner (line-and-space patterns having different directions of the cycle are present in a mixed manner), then it is possible to obtain the high image formation performance even when the numerical aperture NA of the projection optical system is large, by using, in combination, the zonal illumination method and the polarized illumination method in which the light is linearly polarized in the tangential direction of the circle having the center of the optical axis, as disclosed in Japanese Patent Application Laid-open No. 6-53120 as well. For example, when a phase shift mask of the half tone type having a transmittance of 6 % (pattern of a half pitch of about 63 nm) is illuminated by using, in combination, the zonal illumination method (zonal ratio: 3/4) and the polarized illumination method in which the light is linearly polarized in the tangential direction of the circle having the center of the optical axis, the depth of focus (DOF) can be increased by about 250 nm as compared with a case in which the random polarized light beam is used, provided that the illumination $\sigma$ is 0.95, and the numerical aperture of the projection optical system PL is NA = 1.00. In the case of a pattern having a half pitch of about 55 nm with a numerical aperture NA = 1.2 of the projection optical system, the depth of focus can be increased by about 100 nm.

The substrate P, which is usable in the respective embodiments described above, is not limited to the semiconductor wafer for producing the semiconductor device. Those applicable include, for example, the glass substrate for the display device, the ceramic wafer for the thin film magnetic head, and the master plate (synthetic silica glass, silicon wafer) for the mask or the reticle to be used for the exposure apparatus.

As for the exposure apparatus EX, the present invention is also applicable to the scanning type exposure apparatus (scanning stepper) based on the step-and-scan system for performing the scanning exposure for the pattern of the mask M by synchronously moving the mask M and the substrate P as well as the projection exposure apparatus (stepper) based on the step-and-repeat system for performing the full field exposure with the pattern of the mask M in a state in which the mask M and the substrate P are allowed to stand still, while successively step-moving the substrate P.

As for the exposure apparatus EX, the present invention is also applicable to the exposure apparatus of the system in which the substrate P is subjected to the full field exposure by using a projection optical system (for example, a dioptric type projection optical system including no catoptric element with a reduction magnification of 1/8) with a reduction image of a first pattern in a state in which the first pattern and the substrate P are allowed to substantially stand still. In this case, the present invention is also applicable to the full field exposure apparatus based on the stitch system in which the substrate P is subjected to the full field exposure while partially overlaying a reduction image of a second pattern on the first pattern by using the projection optical system in a state in which the second pattern and the substrate P are allowed to substantially stand still thereafter. As for the exposure apparatus based on the stitch system, the present invention is also applicable to the exposure apparatus based on the step-and-stitch system in which at least two patterns are partially overlaid and transferred on the substrate P, and the substrate P is successively moved. The present invention is also applicable to the exposure apparatus provided with a measuring stage which is provided with members and sensors for the measurement separately from the stage which holds the substrate P. The exposure apparatus provided with the measuring stage is described, for example, in European Patent Publication No. 1,041,357, contents of which are incorporated herein by reference within a range of permission of the domestic laws and ordinances of the state designated or selected in this international application.

The present invention is also applicable to the twin-stage type exposure apparatus. The structure and the exposure operation of the twin-stage type exposure apparatus are disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407, contents of which are incorporated herein by reference within a range of permission of the domestic laws and ordinances of the state designated or selected in this international application.

As for the type of the exposure apparatus EX, the present invention is not limited to the exposure apparatus for the semiconductor device production which exposes the substrate P with the semiconductor device pattern. The present invention is also widely applicable, for example, to the exposure apparatus for producing the liquid crystal display device or for producing the display as well as the exposure apparatus for producing, for example, the thin film magnetic head, the image pickup device (CCD), the reticle, or the mask.

In the embodiment described above, the light-transmitting type mask (reticle), in which the predetermined light-shielding pattern (or the phase pattern or the light-reducing pattern) is formed on the light-transmissive substrate, is used. However, in place of the reticle, it is also allowable to use an electronic mask for forming a transmission pattern, a reflection pattern, or a light emission pattern on the basis of the electronic data of the pattern to be subjected to the exposure, as disclosed, for example, in United States Patent No. 6,778,257. The present invention is also applicable to the exposure apparatus (lithography system) for forming the line-and-space pattern on the wafer W by forming interference fringes on the wafer W as disclosed in the pamphlet of International Publication No. 2001/035168.

In the embodiment described above, the exposure apparatus, in which the space between the projection optical system PL and the substrate P is locally filled with the liquid, is adopted. However, the present invention is also applicable to the liquid immersion exposure apparatus in which the entire surface of the substrate as the exposure objective is covered with the liquid. The structure and the exposure operation of the liquid immersion exposure apparatus in which the entire surface of the substrate as the exposure objective is covered with the liquid are described in detail, for example, in Japanese Patent Application Laid-open Nos. 6-124873 and 10-303114 and United States Patent No. 5,825,043, contents of which are incorporated herein by reference within a range of permission of the domestic laws and ordinances of the state designated or selected in this international application.

When the linear motor is used for the substrate stage PST and/or the mask stage MST, it is allowable to use any one of those of the air floating type based on the use of the air bearing and those of the magnetic floating type based on the use of the Lorentz's force or the reactance force. Each of the stages PST, MST may be either of the type in which the movement is effected along the guide or of the guideless type in which no guide is provided. An example of the use of the linear motor for the stage is disclosed in United States Patent Nos. 5,623,853 and 5,528,118, contents of which are incorporated herein by reference respectively within a range of permission of the domestic laws and ordinances of the state designated or selected in this international application.

As for the driving mechanism for each of the stages PST, MST, it is also allowable to use a plane motor in which a magnet unit provided with two-dimensionally arranged magnets and an armature unit provided with two-dimensionally arranged coils are opposed to one another, and each of the stages PST, MST is driven by the electromagnetic force. In this arrangement, any one of the magnet unit and the armature unit is connected to the stage PST, MST, and the other of the magnet unit and the armature unit is provided on the side of the movable surface of the stage PST, MST.

The reaction force, which is generated in accordance with the movement of the substrate stage PST, may be mechanically released to the floor (ground) by using a frame member so that the reaction force is not transmitted to the projection optical system PL. The method for handling the reaction force is disclosed in detail, for example, in United States Patent No. 5,528,118 (Japanese Patent Application Laid-open No. 8-166475), contents of which are incorporated herein by reference within a range of permission of the domestic laws and ordinances of the state designated or selected in this international application.

The reaction force, which is generated in accordance with the movement of the mask stage MST, may be mechanically released to the floor (ground) by using a frame member so that the reaction force is not transmitted to the projection optical system PL. The method for handling the reaction force is disclosed in detail, for example, in United States Patent No. 5,874,820 (Japanese Patent Application Laid-open No. 8-330224), contents of which are incorporated herein by reference within a range of permission of the domestic laws and ordinances of the state designated or selected in this international application.

As described above, the exposure apparatus EX according to the embodiment of the present invention is produced by assembling the various subsystems including the respective constitutive elements as defined in claims so that the predetermined mechanical accuracy, the electric accuracy, and the optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which, for example, the temperature and the cleanness are managed.

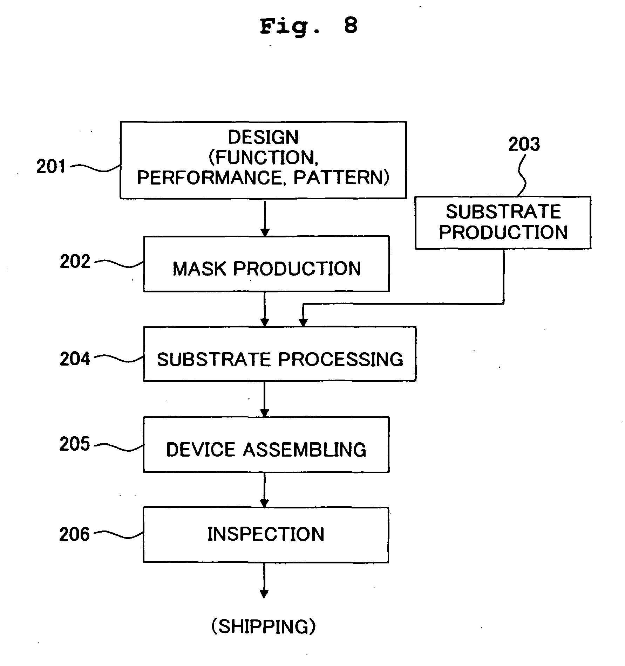

As shown in Fig. 8, the microdevice such as the semiconductor device is produced by performing, for example, a step 201 of designing the function and the performance of the microdevice, a step 202 of manufacturing a mask (reticle) based on the designing step, a step 203 of producing a substrate as a base material for the device, an exposure process step 204 of exposing the substrate with a pattern of the mask by using the exposure apparatus EX of the embodiment described above, a step 205 of assembling the device (including a dicing step, a bonding step, and a packaging step), and an inspection step 206.

Fifth Embodiment

Next, an explanation will be made about another embodiment of the recovery method with the first liquid recovery mechanism 20 in relation to the first to fourth embodiments described above. In this embodiment, only the liquid LQ is recovered from the first recovery port 22. Accordingly, the occurrence of vibration caused by the liquid recovery is suppressed.

The principle of the liquid recovery operation with the first liquid recovery mechanism 20 of this embodiment will be explained below with reference to a schematic view shown in Fig. 9. For example, a thin plate-shaped porous member or perforated member (mesh member), which is formed with a large number of pores, can be used as a porous member 25 for the first recovery port 22 of the first liquid recovery mechanism 20 explained in relation to Figs. 1 to 5 and 7. In this embodiment, the porous member is formed of titanium. In this embodiment, only the liquid LQ is recovered from the pores of the porous member 25 by controlling the pressure difference between the upper surface and the lower surface of the porous member 25 so that a predetermined condition is satisfied as described later on, in a state in which the porous member 25 is wet. The parameters concerning the predetermined condition include, for example, the pore size of the porous member 25, the contact angle (affinity) of the porous member 25 with respect to the liquid LQ, and the suction force of the first liquid recovery section 21 (pressure at the upper surface of the porous member 25).

Fig. 9 shows a magnified view illustrating a partial cross section of the porous member 25, which depicts a specified example of the liquid recovery to be performed via the porous member 25. The substrate P is arranged under the porous member 25. The gas space and the liquid space are formed between the porous member 25 and the substrate P. More specifically, the gas space is formed between the substrate P and the first pore 25Ha of the porous member 25, and the liquid space is formed between the substrate P and the second pore 25Hb of the porous member 25. Such a situation arises, for example, at the end of the liquid immersion area AR2 shown in Fig. 2, or such a situation arises by the generation of the gas in the liquid immersion area AR2 due to any cause. A flow passage space, which forms a part of the first recovery flow passage 24, is formed over the porous member 25.

With reference to Fig. 9, when the following condition holds:

$$(4 \times \gamma \times \cos\theta)/d \geq (Pa - Pb) \qquad \qquad ...(3)$$

wherein Pa represents the pressure of the space between the first pore 25Ha of the porous member 25 and the substrate P (pressure at the lower surface of the porous member 25), Pb represents the pressure of the flow passage space over the porous member 25 (pressure at the upper surface of the porous member 25), d represents the pore size (diameter) of each of first and second pores 25Ha, 25Hb, $\theta$ represents the contact angle of the porous member 25 (inside of the pore 25H) with respect to the liquid LQ, and $\gamma$ represents the surface tension of the liquid LQ; then, as shown in Fig. 9, even when the gas space is formed on the lower side of the first pore 25Ha of the porous member 25 (on the side of the substrate P), the gas, which is in the space on the lower side of the porous member 25, can be prevented from any movement to (inflow into) the space disposed on the upper side of the porous member 25 via the pore 25Ha. That is, the interface between the liquid LQ and the gas is maintained in the pore 25Ha of the porous member 25 by optimizing the contact angle $\theta$, the pore size d, the surface tension $\gamma$ of the liquid LQ, and the pressures Pa, Pb to satisfy the condition represented by the expression (3). Thus, it is possible to suppress the inflow of the gas from the first pore 25Ha. On the other hand, the liquid space is formed on the lower side of the second pore 25Hb of the porous member 25 (on the side of the substrate P). Therefore, it is possible to recover only the liquid LQ via the second pore 25Hb.

In the case of the condition represented by the expression (3) described above, the hydrostatic pressure of the liquid LQ on the porous member 25 is not considered in order to simplify the explanation.

In this embodiment, the first liquid recovery mechanism 20 controls the suction force of the first liquid recovery section 21 to adjust the pressure of the flow passage space over the porous member 25 so that the expression (3) described above is satisfied, provided that the pressure Pa of the space under the porous member 25, the diameter d of the pore 25H, the contact angle $\theta$ of the porous member 25 (inner side surface of the pore 25H) with respect to the liquid LQ, and the surface tension $\gamma$ of the liquid (pure water) LQ are constant. However, with reference to the expression (3), as (Pa - Pb) is larger, i.e., as $(4 \times \gamma \times \cos\theta)/d$ is lager, the pressure Pb becomes to be controlled more easily to satisfy the expression (3). Therefore, it is desirable that the diameter d of the pore 25Ha, 25Hb and the contact angle $\theta$ of the porous member 25 with respect to the liquid LQ ($0 < \theta < 90°$) are made as small as possible. In the explanation based on the use of, for example, Figs. 1, 2, 4, 5, 7, and 9 described above, the first space K1 between the substrate P and the lower surface 2S of the last optical element 2G is filled with the liquid LQ1 in the state in which the lower surface 2S of the last optical element 2G is opposed to the substrate P. However, it goes without saying that the space between the projection optical system PL and another member (for example, the upper surface 51 of the substrate stage PST) can be also filled with the liquid when the projection optical system PL is opposed to the another member.

INDUSTRIAL APPLICABILITY

According to the present invention, the optical element, which is possibly polluted by the liquid immersion exposure, can be exchanged easily and quickly. Therefore, it is possible to maintain the exposure accuracy and the measurement accuracy satisfactorily. Further, it is possible to suppress the decrease in the throughput and the increase in the maintenance cost for the exposure apparatus.

**Claims**

1. An exposure apparatus (EX) which is configured to expose a substrate (P) by radiating an exposure light beam (EL) onto the substrate (P), the exposure apparatus comprising:

   a projection optical system (PL) which is provided with a plurality of elements (2A - 2G) including a first element (2G) closest to an image plane of the projection optical system and a second element (2F) next closest to the image plane of the projection optical system;
   a support member (PK, 70) which supports the first element (2G) of the projection optical system in a substantially stationary state with respect to an optical axis (AX) of the projection optical system;
   a first space (K1) which is formed on a side of one surface of the first element (2G) and which is configured to be filled with a liquid (LQ1); and
   a second space (K2) which is formed on a side of the other surface of the first element (2G) independently from the first space (K1) and which is configured to be filled with a liquid (LQ2),
   wherein, in use, a liquid immersion area (AR2), with which a part of a surface of the substrate is covered, is formed with the liquid (LQ1) in the first space (K1), and the substrate is exposed by radiating the exposure light beam onto the substrate through the liquid (LQ1) in the first space (K1) and the liquid (LQ2) in the second space K2;
   the exposure apparatus further comprising
   a first liquid supply mechanism (10) which is configured to supply the liquid (LQ1) to the first space (K1);
   a first liquid recovery mechanism (20) which is configured to recover the liquid (LQ1) supplied to the first space (K2); and
   a flow passage-forming member (70) which is arranged around the first element (2G) to oppose to the substrate (P), and which is formed with a flow passage for the liquid to be recovered by the first liquid recovery mechanism (20), **characterized in that** the flow passage-forming member is capable of retaining the liquid between the substrate and the flow passage-forming member, and **in that**
a recovery port (22) is formed at least at a part of a lower surface of the flow passage-forming member (70) to recover the liquid.

2. The exposure apparatus according to claim 1, wherein the liquid in the first space is different from the liquid in the second space.

3. The exposure apparatus according to claim 1 or 2, wherein:

   a support member (PK) is provided, which supports the first element (2G) and the second element (2F).

4. The exposure apparatus according to claim 1 or 2, wherein the first element (2G) is supported separately from other elements which construct the projection optical system (PL).

5. The exposure apparatus according to any one of claims 1 to 4 , wherein the flow passage-forming member (70) is formed with a flow passage for the liquid to be supplied by the first liquid supply mechanism (10).

6. The exposure apparatus according to claim 5, wherein the flow passage-forming member (70) has liquid supply ports of the first liquid supply mechanism (10), which are formed on both sides of the first element (2G) respectively.

7. The exposure apparatus according to any one of claims 1 to 6, wherein a distance between the first element (2G) and the substrate (P) is longer than a distance between the lower surface of the flow passage-forming member (70) and the substrate.

8. The exposure apparatus according to claim 7, wherein a distance between the first element (2G) and the second element (2F) is shorter than the distance between the first element (2G) and the substrate (P).

9. The exposure apparatus according to claim 4, wherein the first element is held by the flow passage-forming member (70).

10. The exposure apparatus according to claim 9, wherein the flow passage-forming member (70) is also formed with a flow passage for supplying the liquid to the second space (K2) independently from the supply of the liquid to the first space (K1).

11. The exposure apparatus according to any one of claims 1 to 10, further comprising a second liquid supply mechanism (30) which supplies the liquid to the second space (K2).

12. The exposure apparatus according to claim 11, further comprising a second liquid recovery mechanism (60) which recovers the liquid supplied to the second space (K2).

13. The exposure apparatus according to any one of claims 1 to 12, wherein the liquid in the second space (K2) is exchangeable.

14. The exposure apparatus according to any one of claims 1 to 13, wherein the second liquid supply mechanism (30) is configured to stop the supply of the liquid during the exposure for the substrate.

15. The exposure apparatus according to any one of claims 1 to 14, further comprising a connecting hole (74) which connects the first space (K1) and the second space (K2).

16. The exposure apparatus according to claim 15, wherein a porous material (74P) is provided in the connecting hole (74).

17. The exposure apparatus according to any one of claims 1 to 16, wherein the first element (2G) is a parallel flat plate.

18. The exposure apparatus according to any one of claims 1 to 17, wherein the liquid in the first space (K1) is water.

19. The exposure apparatus according to claim 18, wherein the liquid in the second space (K2) is water.

20. The exposure apparatus according to any one of claims 1 to 19, wherein:

the first element (2G) has a first surface which is arranged to be opposed to a surface of the substrate (P) and through which the exposure light beam passes, and a second surface which is arranged to be opposed to the second element (2F) and through which the exposure light beam passes;
the second element (2F) has a third surface which is arranged to be opposed to the second surface of the first element (2G) and through which the exposure light beam passes; and
the second surface has an areal size which is the same as an areal size of the third surface or which is smaller than the areal size of the third surface.

21. The exposure apparatus according to any one of claims 1 to 20, wherein the first element (2G) has no refractive power.

22. The exposure apparatus according to any one of claims 1 to 21, wherein the first element (2G) is detachable from the projection optical system while exerting no influence on an optical characteristic of the projection optical system.

23. The exposure apparatus according to any one of claims 1 to 22, wherein the first space (K1) is a space which is open to surroundings, and the second space (K2) is a space which is closed from surroundings.

24. The exposure apparatus according to any one of claims 1 to 23, wherein the second space (K2) is defined between the first element (2G) and the second element (2F).

25. The exposure apparatus according to any one of claims 1 to 24, wherein the liquid flows, in use, in parallel to the substrate (P) from the flow passages formed in the flow passage-forming member (70) to the first space (K2).

26. The exposure apparatus according to any one of claims 1 to 25, wherein the first liquid recovery mechanism (20) has a recovery port (22) for recovering the liquid from the first space (K1), and a porous member (22P) is arranged in the recovery port.

27. The exposure apparatus according to 26, wherein a condition of $(4 \times \gamma \times \cos\theta)/d \geq (Pa - Pb)$ holds provided that Pa represents a pressure of a space between the porous member and the substrate, Pb represents a pressure of a flow passage space over the porous member, d represents a pore size of the porous member, $\theta$ represents a contact angle of the porous member with respect to the liquid, and $\gamma$ represents a surface tension of the liquid.

28. A method for producing a device, comprising using the exposure apparatus as defined in any one of claims 1 to 27.

29. An exposure method for exposing a substrate (P) by radiating an exposure light beam (EL) onto the substrate via a projection optical system (PL) provided with a plurality of elements (2A - 2g), the exposure method comprising:

providing a liquid (LQ1) to a first space (K1) disposed on a light-exit side of a first element (2G) closest to an image plane of the projection optical system among the plurality of elements; supplying a liquid (LQ2) to a second space (K2) disposed on a light-incident side of the first element (2G) and isolated from the first space (K1); and
exposing the substrate by radiating the exposure light beam onto the substrate through the liquid in the first space and the liquid in the second space, **characterized by** the step of:
recovering the liquid (LQ1) from the first space (K1) via a recovery port (22) formed at least at a part of a lower surface of a flow passage-forming member (70) which is arranged around the first element (2G) to oppose to the substrate (P), which is capable of retaining the liquid between the substrate and the flow passage-forming member, and which is formed with a flow passage (24) for the liquid to be recovered through the recovery port.

30. The exposure method according to claim 29, wherein the liquid is supplied to each of the first space (K1) and the second space (K2) independently when the liquid is provided to each of the first space and the second space.

31. The exposure method according to claim 29 or 30, further comprising recovering the liquid from each of the first space (K1) and the second space (K2) independently.

32. The exposure method according to any one of claims 29 to 31, wherein the liquid flows to the first space (K1) in parallel to the substrate when the liquid is provided to the first space.

33. The exposure method according to any one of claims 29 to 32, wherein a liquid immersion area (AR2) is formed on a part of the substrate (P) with the liquid in the first space (K1).

34. The exposure method according to claim 33, wherein the liquid immersion area (AR2) is formed on the part of the substrate (P) by retaining the liquid between the flow passage-forming member (70) and the substrate (P).

35. The exposure method according to any one of claims 29 to 34, wherein a distance between the first element (2G) and the substrate (P) is longer than a distance between the lower surface of the flow passage-forming member (70) and the substrate (P).

36. The exposure method according to claim 35, wherein:

the projection optical system has a second element (2F) which is next closest to the image plane of the projection optical system with respect to the first element (2G); and
a distance between the first element (2G) and the second element (2F) is shorter than the distance between the first element (2G) and the substrate (P).

37. The exposure method according to any one of claims 29 to 36, wherein the supply of the liquid to the second space (K2) is stopped in a state in which the second space is filled with the liquid during a period in which the exposure light beam is radiated onto the substrate.

**Patentansprüche**

1. Belichtungsvornchtung (EX), die dazu ausgebildet ist, ein Substrat (P) zu belichten, indem ein Lichtstrahl (EL) auf das Substrat (P) gestrahlt wird, welche Belichtungsvorrichtung aufweist:

ein optisches Projektionssystem (PL), das eine Vielzahl von Elementen (2A-2G) aufweist, einschließlich eines ersten Elements (2G), das einer Bildebene des optischen Projektionssystems am nächsten liegt, und eines zweiten Elements (2F), das der Bildebene des optischen Projektionssystems am zweitnächsten liegt,
ein Tragelement (PK, 70), das das erste Element (2G) des optischen Projektionssystems in einem im wesentlichen stationären Zustand in Bezug auf eine optische Achse (AX) des optischen Projektionssystems hält,
einen ersten Raum (K1), der auf einer Seite einer Oberfläche des ersten Elements (2G) gebildet wird und dazu konfiguriert ist, mit einer Flüssigkeit (LQ1) gefüllt zu werden, und
einen zweiten Raum (K2), der auf einer Seite der anderen Oberfläche des ersten Elements (2G) und getrennt von dem ersten Raum (K1) gebildet ist und dazu konfiguriert ist, mit einer Flüssigkeit (LQ2) gefüllt zu werden, wobei im Gebrauch in dem ersten Raum (K1) ein Eintauchgebiet (AR2) mit der Flüssigkeit (LQ1) gebildet wird, mit der ein Teil einer Oberfläche des Substrats bedeckt ist, und das Substrat belichtet wird, indem der Lichtstrahl durch die Flüssigkeit (LQ1) in den ersten Raum (K1) und die Flüssigkeit (LQ2) in den zweiten Raum (K2) hindurch auf das Substrat gestrahlt wird,

wobei die Belichtungsvorrichtung weiterhin aufweist:

einen ersten Flüssigkeitszufuhrmechanismus (10) der dazu konfiguriert ist, die Flüssigkeit (LQ1) in den ersten Raum (K1) zuzuführen,
einen ersten Rückgewinnungsmechanismus (20) für Flüssigkeit, der dazu konfiguriert ist, die Flüssigkeit (LQ1), die in den ersten Raum (K1) zugeführt wurde, zurückzugewinnen, und
ein Kanalbildungselement (70), das um das erste Element (2G) herum angeordnet ist, so dass es dem Substrat (P) gegenüberliegt, und dass einen Strömungskanal für die Flüssigkeit aufweist, die von dem ersten Rückgewinnungsmechanismus (20) zurückzugewinnen ist,
**dadurch gekennzeichnet, dass** das Kanalbildungselement in der Lage ist, die Flüssigkeit zwischen dem Substrat und dem Kanalbildungselement zu halten, und dass
ein Rückgewinnungsport (22) zum Zurückgewinnen der Flüssigkeit zumindest an einem Teil einer unteren Oberfläche des Kanalbildungselements (70) gebildet ist.

2. Belichtungsvorrichtung nach Anspruch 1, bei der die Flüssigkeit in dem ersten Raum von der Flüssigkeit in dem zweiten Raum verschieden ist.

3. Belichtungsvorrichtung nach Anspruch 1 oder 2, bei der:

   ein Tragelement (PK) vorgesehen ist, dass das erste Element (2G) und das zweite Element (2F) trägt.

4. Belichtungsvorrichtung nach Anspruch 1 oder 2, bei der das erste Element (2G) getrennt von den anderen Elementen abgestützt ist, die das optischen Projektionssystem (PL) bilden,

5. Belichtungsvorrichtung nach einem der Ansprüche 1 bis 4, bei der das Kanalbildungselement (70) einen Strömungskanal für die Flüssigkeit aufweist, die durch den ersten Zufuhrmechanismus (10) zuzuführen ist.

6. Belichtungsvorrichtung nach Anspruch 5, bei der das Kanalbildungselement (70) Zufuhrports des ersten Zufuhrmechanismus (10) für Flüssigkeit aufweist, die auf beiden Seiten des ersten Elements (2G) gebildet sind.

7. Belichtungsvorrichtung nach einem der Ansprüche 1 bis 6, bei der ein Abstand zwischen dem ersten Element (2G) und dem Substrat (P) größer ist als ein Abstand zwischen der unteren Oberfläche des Kanalbildungselements (70) und dem Substrat.

8. Belichtungsvorrichtung nach Anspruch 7, bei der ein Abstand zwischen dem ersten Element (2G) und dem zweiten Element (2F) kürzer ist als der Abstand zwischen dem ersten Element (2G) und dem Substrat (P).

9. Belichtungsvorrichtung nach Anspruch 4, bei der das erste Element durch das Kanalbildungselement (70) gehalten ist.

10. Belichtungsvorrichtung nach Anspruch 9, bei der das Kanalbildungselement (70) auch einen Strömungskanal zum Zuführen der Flüssigkeit zu dem zweiten Raum (K2) unabhängig von der Zufuhr der Flüssigkeit zu dem ersten Raum (K1) aufweist.

11. Belichtungsvorrichtung nach einem der Ansprüche 1 bis 10, mit einem zweiten Zufuhrmechanismus (30) für Flüssigkeit, der die Flüssigkeit in den zweiten Raum (K2) zuführt.

12. Belichtungsvorrichtung nach Anspruch 11, mit einem zweiten Rückgewinnungsmechanismus (60) für Flüssigkeit, der die in den zweiten Raum (K2) zugeführte Flüssigkeit zurückgewinnt.

13. Belichtungsvorrichtung nach einem der Ansprüche 1 bis 12, bei der die Flüssigkeit in dem zweiten Raum (K2) austauschbar ist.

14. Belichtungsvorrichtung nach einem der Ansprüche 1 bis 13, bei der der zweite Zufuhrmechanismus (30) für Flüssigkeit dazu konfiguriert ist, die Zufuhr der Flüssigkeit während der Belichtung des Substrats zu unterbrechen.

15. Belichtungsvorrichtung nach einem der Ansprüche 1 bis 14, mit einem Verbindungsloch (74), das den ersten Raum (K1) mit dem zweiten Raum (K2) verbindet.

16. Belichtungsvorrichtung nach Anspruch 15, bei der in dem Verbindungsloch (74) ein poröses Material (74P) vorgesehen ist.

17. Belichtungsvorrichtung nach einem der Ansprüche 1 bis 16, bei der das erste Element (2G) eine planparallele Platte ist.

18. Belichtungsvorrichtung nach einem der Ansprüche 1 bis 17, bei der die Flüssigkeit in dem ersten Raum (K1) Wasser ist.

19. Belichtungsvorrichtung nach Anspruch 18, bei der die Flüssigkeit in dem zweiten Raum (K2) Wasser ist.

20. Belichtungsvorrichtung nach einem der Ansprüche 1 bis 19, bei der:

   das erste Element (2G) eine erste Oberfläche hat, die so angeordnet ist, dass sie einer Oberfläche des Substrats (P) gegenüberliegt, und durch welche der Belichtungs-Lichtstrahl hindurchgeht, und eine zweite Oberfläche, die so angeordnet ist, dass sie dem zweiten Element (2F) gegenüberliegt und durch welche der Belichtungs-Lichtstrahl hindurchgeht,

das zweite Element (2F) eine dritte Oberfläche hat, die so angeordnet ist, dass sie der zweiten Oberfläche des ersten Elements (2G) gegenüberliegt und durch welche der Belichtungs-Lichtstrahl hindurchgeht, und

die zweite Oberfläche eine Flächenausdehnung hat, die gleich einer Flächenausdehnung der dritten Oberfläche ist oder die kleiner ist als die Flächenausdehnung der dritten Oberfläche.

21. Belichtungsvorrichtung nach einem der Ansprüche 1 bis 20, bei der das erste Element (2G) nicht lichtbrechend ist.

22. Belichtungsvorrichtung nach einem der Ansprüche 1 bis 21, bei der das erste Element (2G) von dem optischen Projektionssystem lösbar ist, ohne dass eine optische Eigenschaft des optischen Projektionssystems beeinflusst wird.

23. Belichtungsvorrichtung nach einem der Ansprüche 1 bis 22, bei der der erste Raum (K1) ein Raum ist, der zur Umgebung offen ist, und der zweite Raum (K2) ein Raum ist, der gegenüber der Umgebung abgeschlossen ist.

24. Belichtungsvorrichtung nach einem der Ansprüche 1 bis 23, bei der der zweite Raum (K2) zwischen dem ersten Element (2G) und dem zweiten Element (2F) begrenzt ist.

25. Belichtungsvorrichtung nach einem der Ansprüche 1 bis 24, bei der die Flüssigkeit im Gebrauch parallel zu dem Substrat (P) von den in dem Kanalbildungselement (70) gebildeten Strömungskanälen zu dem ersten Raum (K1) fließt.

26. Belichtungsvorrichtung nach einem der Ansprüche 1 bis 25, bei der der erste Rückgewinnungsmechanismus (20) für Flüssigkeit einen Rückgewinnungsport (22) zum Zurückgewinnen der Flüssigkeit aus dem ersten Raum (K1) hat und ein poröses Element (22P) in dem Rückgewinnungsport angeordnet ist.

27. Belichtungsvorrichtung nach Anspruch 26, bei der eine Bedingung $(4 \times \gamma \times \cos\theta) / d \geq (Pa - Pb)$ gilt, wobei Pa einen Druck eines Raumes zwischen dem porösen Element und dem Substrat angibt, Pb einen Druck eines Strömungsraumes über dem porösen Element angibt, d eine Porengröße des porösen Elements angibt, $\theta$ einen Benetzungs-winkel des porösen Elements in Bezug auf die Flüssigkeit angibt, und $\gamma$ eine Oberflächenspannung der Flüssigkeit angibt.

28. Verfahren zur Herstellung eines Bauelements unter Verwendung der Belichtungsvorrichtung nach einem der Ansprüche 1 bis 27.

29. Belichtungsverfahren zum Belichten eines Substrats (P) durch Bestrahlen des Substrats mit einem Lichtstrahl (EL) über ein optisches Projektionssystem (PL), das eine Vielzahl von Elementen (2A-2G) aufweist, welches Verfahren umfasst:

Bereitstellen einer Flüssigkeit (LQ1) in einem ersten Raum (K1) auf einer Lichtaustrittsseite eines ersten Elements (2G), das unter der Vielzahl der Elemente einer Bildebene des optischen Projektionssytems am nächsten liegt, Zuführen einer Flüssigkeit (LQ2) zu einem zweiten Raum (K2), der auf einer Lichteintrittsseite des ersten Elements (2G) angeordnet und von dem ersten Raum (K1) isoliert ist, und
Belichten des Substrats durch Bestrahlen des Substrats mit dem Lichtstrahl durch die Flüssigkeit in dem ersten Raum und die Flüssigkeit in dem zweiten Raum hindurch, **gekennzeichnet durch** den Schritt der:

Rückgewinnung der Flüssigkeit (LQ1) aus dem ersten Raum (K1) über einen Rückgewinnungsport (22), der zumindest in einem Teil einer unteren Oberfläche eines Kanalbildungselements (70) gebildet ist, das um das erste Element (2G) herum angeordnet ist und dem Substrat (P) gegenüberliegt und in der Lage ist, die Flüssigkeit zwischen dem Substrat und dem Kanalbildungselement zu halten, und dass einen Strömungskanal (24) für die **durch** den Rückgewinnungsport zurückzugewinnende Flüssigkeit aufweist.

30. Belichtungsverfahren nach Anspruch 29, bei dem die Flüssigkeit zu jedem der ersten und zweiten Räume (K1, K2) unabhängig zugeführt wird, wenn die Flüssigkeit zu jedem der ersten und zweiten Räume zugeführt wird.

31. Belichtungsverfahren nach Anspruch 29 oder 30, mit Zurückgewinnung der Flüssigkeit aus jedem der ersten und zweiten Räume (K1, K2) unabhängig voneinander.

**32.** Belichtungsverfahren nach einem der Ansprüche 29 bis 31, bei dem die Flüssigkeit parallel zu dem Substrat in den ersten Raum (K1) fließt, wenn die Flüssigkeit zu dem ersten Raum zugeführt wird.

**33.** Belichtungsverfahren nach einem der Ansprüche 29 bis 32, bei dem mit der Flüssigkeit in dem ersten Raum (K1) ein Eintauchgebiet (AR2) auf einem Teil des Substrats (P) gebildet wird.

**34.** Belichtungsverfahren nach Anspruch 33, bei dem das Eintauchgebiet (AR2) auf dem Teil des Substrats (P) gebildet wird, in dem die Flüssigkeit zwischen dem Kanalbildungselement (70) und dem Substrat (P) gehalten wird.

**35.** Belichtungsverfahren nach einem der Ansprüche 29 bis 34, bei dem ein Abstand zwischen dem ersten Element (2G) und dem Substrat (P) größer ist als ein Abstand zwischen der unteren Oberfläche des Kanalbildungselements (70) und dem Substrat (P).

**36.** Belichtungsverfahren nach Anspruch 35, bei dem:

das optische Projektionssystem ein zweites Element (2F) hat, das der Bildebene des optischen Projektionssystems in Bezug auf das erste Element (2G) am zweitnächsten liegt, und
ein Abstand zwischen dem ersten Element (2G) und dem zweiten Element (2F) kürzer ist als der Abstand zwischen dem ersten Element (2G) und dem Substrat (P).

**37.** Belichtungsverfahren nach einem der Ansprüche 29 bis 36, bei dem die Zufuhr der Flüssigkeit zu dem zweiten Raum (K2) in einem Zustand unterbrochen wird, in dem der zweite Raum während einer Periode, in der das Substrat mit dem Lichtstrahl bestrahlt wird, mit der Flüssigkeit gefüllt ist.

**Revendications**

**1.** Dispositif d'exposition (EX) lequel est configuré pour exposer un substrat (P) en irradiant un faisceau de lumière d'exposition (EL) sur le substrat (P), le dispositif d'exposition comportant :

un système optique de projection (PL) muni d'une pluralité d'éléments (2A - 2G) incluant un premier élément (2G) le plus proche d'un plan d'image du système optique de projection et un second élément (2F) le deuxième plus proche du plan d'image du système optique de projection,
un élément de support (PK, 70) qui supporte le premier élément (2G) du système optique de projection dans un état sensiblement stationnaire par rapport à un axe optique (AX) du système optique de projection,
un premier espace (K1) formé sur un côté d'une surface du premier élément (2G) et qui est configuré pour être rempli d'un liquide (LQ1), et
un second espace (K2) formé sur un côté de l'autre surface du premier élément (2G) indépendamment du premier espace (K1) et configuré pour être rempli d'un liquide (LQ2),
dans lequel, en utilisation, une zone d'immersion de liquide (AR2), dont une partie d'une surface du substrat est recouverte, est formée avec le liquide (LQ1) dans le premier espace (K1), et le substrat est exposé en rayonnant le faisceau de lumière d'exposition sur le substrat à travers le liquide (LQ1) dans le premier espace (K1) et le liquide (QL2) dans le second espace (K2),
le dispositif d'exposition comportant en outre
un premier mécanisme d'alimentation en liquide (10) configuré pour délivrer le liquide (LQ1) au premier espace (K1),
un premier mécanisme de récupération de liquide (20) configuré pour récupérer le liquide (LQ1) délivré au premier espace (K1), et
un élément de formation de passage d'écoulement (70) agencé autour du premier élément (2G) en opposition au substrat (P), et formé avec un passage d'écoulement pour le liquide à récupérer par le premier mécanisme de récupération de liquide (20), **caractérisé en ce que** l'élément de formation de passage d'écoulement est capable de conserver le liquide entre le substrat et l'élément de formation de passage d'écoulement, et **en ce que** un orifice de récupération (22) est formé au moins dans une partie d'une surface inférieure de l'élément de formation de passage d'écoulement (70) pour récupérer le liquide.

**2.** Dispositif d'exposition selon la revendication 1,

dans lequel le liquide dans le premier espace est différent du liquide dans le second espace.

3.  Dispositif d'exposition selon la revendication 1 ou 2, dans lequel :

    un élément de support (PK) est fourni, lequel supporte le premier élément (2G) et le second élément (2F).

4.  Dispositif d'exposition selon la revendication 1 ou 2, dans lequel le premier élément (2G) est supporté séparément des autres éléments qui constituent le système optique de projection (PL).

5.  Dispositif d'exposition selon l'une quelconque des revendications 1 à 4, dans lequel l'élément de formation de passage d'écoulement (70) est formé d'un passage d'écoulement pour le liquide à délivrer par le premier mécanisme d'alimentation en liquide (10).

6.  Dispositif d'exposition selon la revendication 5, dans lequel l'élément de formation de passage d'écoulement (70) a des orifices d'alimentation en liquide du premier mécanisme d'alimentation en liquide (10), lesquels sont formés sur les deux côtés du premier élément (2G) respectivement.

7.  Dispositif d'exposition selon l'une quelconque des revendications 1 à 6, dans lequel une distance entre le premier élément (2G) et le substrat (P) est plus longue qu'une distance entre la surface inférieure de l'élément de formation de passage d'écoulement (70) et le substrat.

8.  Dispositif d'exposition selon la revendication 7, dans lequel une distance entre le premier élément (2G) et le second élément (2F) est plus courte que la distance entre le premier élément (2G) et le substrat (P).

9.  Dispositif d'exposition selon la revendication 4, dans lequel le premier élément est maintenu par l'élément de formation de passage d'écoulement (70).

10. Dispositif d'exposition selon la revendication 9, dans lequel l'élément de formation de passage d'écoulement (70) est également formé avec un passage d'écoulement pour délivrer le liquide au second espace (K2) indépendamment de l'alimentation du liquide au premier espace (K1).

11. Dispositif d'exposition selon l'une quelconque des revendications 1 à 10, comportant en outre un second mécanisme d'alimentation en liquide (30) lequel délivre le liquide au second espace (K2).

12. Dispositif d'exposition selon la revendication 11, comportant en outre un second mécanisme de récupération de liquide (60) lequel récupère le liquide délivré au second espace (K2).

13. Dispositif d'exposition selon l'une quelconque des revendications 1 à 12, dans lequel le liquide dans le second espace (K2) est échangeable.

14. Dispositif d'exposition selon l'une quelconque des revendications 1 à 13, dans lequel le second mécanisme d'alimentation en liquide (30) est configuré pour arrêter l'alimentation du liquide pendant l'exposition pour le substrat.

15. Dispositif d'exposition selon l'une quelconque des revendications 1 à 14, comportant en outre un trou de connexion (74) lequel connecte le premier espace (K1) et le second espace (K2).

16. Dispositif d'exposition selon la revendication 15, dans lequel le trou de connexion (74) contient un matériau poreux (74P).

17. Dispositif d'exposition selon l'une quelconque des revendications 1 à 16, dans lequel le premier élément (2G) est une plaque plate parallèle.

18. Dispositif d'exposition selon l'une quelconque des revendications 1 à 17, dans lequel le liquide dans le premier espace (K1) est de l'eau.

19. Dispositif d'exposition selon la revendication 18, dans lequel le liquide dans le second espace (K2) est de l'eau.

20. Dispositif d'exposition selon l'une quelconque des revendications 1 à 19, dans lequel :

le premier élément (2G) a une première surface agencée de manière à être opposée à une surface du substrat (P) et via laquelle le faisceau de lumière d'exposition passe, et une seconde surface laquelle est agencée de manière à être opposée au second élément (2F) et à travers laquelle le faisceau de lumière d'exposition passe, le second élément (2F) a une troisième surface laquelle est agencée de manière à être opposée à la deuxième surface du premier élément (2G) et à travers laquelle le faisceau de lumière d'exposition passe, et la seconde surface a une dimension d'aire qui est identique à une dimension d'aire de la troisième surface ou laquelle est inférieure à la dimension d'aire de la troisième surface.

21. Dispositif d'exposition selon l'une quelconque des revendications 1 à 20, dans lequel le premier élément (2G) n'a pas de réfringence.

22. Dispositif d'exposition selon l'une quelconque des revendications 1 à 21, dans lequel le premier élément (2G) est détachable du système optique de projection tout en exerçant aucune influence sur une caractéristique optique du système optique de projection.

23. Dispositif d'exposition selon l'une quelconque des revendications 1 à 22, dans lequel le premier espace (K1) est un espace qui est ouvert sur le milieu extérieur, et le second espace (K2) est un espace qui est fermé vis-à-vis du milieu extérieur.

24. Dispositif d'exposition selon l'une quelconque des revendications 1 à 23, dans lequel le second espace (K2) est défini entre le premier élément (2G) et le second élément (2F).

25. Dispositif d'exposition selon l'une quelconque des revendications 1 à 24, dans lequel le liquide s'écoule, en utilisation, en parallèle au substrat (P) depuis les passages d'écoulement formés dans l'élément de formation de passage d'écoulement (70) vers le premier espace (K1).

26. Dispositif d'exposition selon l'une quelconque des revendications 1 à 25, dans lequel le premier mécanisme de récupération de liquide (20) a un orifice de récupération (22) pour récupérer liquide depuis le premier espace (K1), et un élément poreux (22P) est agencé dans l'orifice de récupération.

27. Dispositif d'exposition selon la revendication 26, dans lequel une condition (4 x $\gamma$ x cos$\theta$/d $\geq$ (Pa- Pb) est vraie à condition que Pa représente une pression d'un espace entre l'élément poreux et le substrat, Pb représente une pression d'un espace de passage d'écoulement sur l'élément poreux, d représente une dimension de pore de l'élément poreux, $\theta$ Représente un angle de contact de l'élément poreux par rapport liquide, et $\gamma$ représente une tension de surface du liquide.

28. Procédé pour produire un dispositif, comportant d'utiliser le dispositif d'exposition selon une quelconque des revendications 1 à 27.

29. Procédé d'exposition pour exposer un substrat (P) en irradiant un faisceau de lumière d'exposition (EL) sur le substrat via un système optique de projection (PL) muni d'une pluralité d'éléments (2A - 2G), le procédé d'exposition comportant les étapes consistant à :

délivrer un liquide (LQ1) à un premier espace (K1) disposé sur un côté de sortie de lumière d'un premier élément (2G) le plus proche d'un plan d'image du système optique de projection parmi la pluralité d'éléments, délivrer un liquide (LQ2) à un second espace (K2) disposé sur un côté d'incidence de lumière du premier élément (2G) et isolé du premier espace (K1), et exposer le substrat en irradiant le faisceau de lumière d'exposition sur le substrat via le liquide dans le premier espace et le liquide dans le second espace, **caractérisé par** l'étape consistant à :

récupérer le liquide (LQ1) du premier espace (K1) via un orifice de récupération (22) formé au moins au niveau d'une partie d'une surface inférieure d'un élément de formation de passage d'écoulement (70) lequel est agencé autour du premier élément (2G) en opposition au substrat (P), lequel est capable de conserver le liquide entre le substrat et l'élément de formation de passage d'écoulement, et lequel est formé avec un passage d'écoulement (24) pour le liquide à récupérer via l'orifice de récupération.

30. Procédé d'exposition selon la revendication 29, dans lequel le liquide est délivré à chacun du premier espace (K1) et du second espace (K2) indépendamment lorsque le liquide est délivré à chacun du premier espace et du second espace.

**31.** Procédé d'exposition selon la revendication 29 ou 30, comportant en outre de récupérer le liquide depuis chacun du premier espace (K1) et du second espace (K2) indépendamment.

**32.** Procédé d'exposition selon l'une quelconque des revendications 29 à 31, dans lequel le liquide circule depuis le premier espace (K1) en parallèle au substrat lorsque le liquide est agencé dans le premier espace.

**33.** Procédé d'exposition selon l'une quelconque des revendications 29 à 32, dans lequel une zone immersion de liquide (AR2) est formée sur une partie du substrat (P) avec le liquide dans le premier espace (K1).

**34.** Procédé d'exposition selon la revendication 33, dans lequel la zone immersion de liquide (AR2) est formée sur la partie du substrat (P) en conservant le liquide entre l'élément de formation de passage d'écoulement (70) et le substrat (P).

**35.** Procédé d'exposition selon l'une quelconque des revendications 29 à 34, dans lequel une distance entre le premier élément (2G) et le substrat (P) est plus longue qu'une distance entre la surface inférieure de l'élément de formation de passage d'écoulement (70) et le substrat (P).

**36.** Procédé d'exposition selon la revendication 35, dans lequel :

le système optique de projection a un second élément (2F) lequel est le deuxième plus proche du plan d'image du système optique de projection par rapport au premier élément (2G), et
une distance entre le premier élément (2G) et le second élément (2F) est plus courte que la distance entre le premier élément (2G) et le substrat (P).

**37.** Procédé d'exposition selon l'une quelconque des revendications 29 à 36, dans lequel l'alimentation du liquide au second espace (K2) est interrompue dans un état dans lequel le second espace est rempli du liquide pendant une période au cours de laquelle le faisceau de lumière d'exposition est irradié sur le substrat.

Fig. 1

# Fig. 2

EP 1 768 169 B1

# Fig. 3

# Fig. 4

EP 1 768 169 B1

# Fig. 5

EP 1 768 169 B1

# Fig. 6

# Fig. 7

EP 1 768 169 B1

# Fig. 8

```
            ┌─────────────────────────┐
            │         DESIGN          │        203
  201 ──────│       (FUNCTION,        │         │
            │  PERFORMANCE, PATTERN)  │    ┌────────────┐
            └─────────────────────────┘    │ SUBSTRATE  │
                        │                   │ PRODUCTION │
                        ▼                   └────────────┘
            ┌─────────────────────────┐
  202 ──────│     MASK PRODUCTION     │
            └─────────────────────────┘
                        │
                        ▼
            ┌─────────────────────────┐
  204 ──────│   SUBSTRATE PROCESSING  │
            └─────────────────────────┘
                        │
                        ▼
            ┌─────────────────────────┐
  205 ──────│    DEVICE ASSEMBLING    │
            └─────────────────────────┘
                        │
                        ▼
            ┌─────────────────────────┐
  206 ──────│       INSPECTION        │
            └─────────────────────────┘
                        │
                        ▼
                   (SHIPPING)
```

# Fig. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 224448 A1
- WO 2004107048 A
- EP 1510871 A
- EP 1670043 A
- EP 1571698 A
- JP 10303114 A
- EP 1420303 A1
- WO 9949504 A
- JP 8037149 A
- US 6674510 B
- JP 4065603 A
- JP 7176468 A
- JP 57117238 A
- JP 2002014005 A
- JP 11016816 A
- EP 1420298 A
- US 20040207824 A
- JP 6188169 A
- JP 6053120 A

- EP 1041357 A
- JP 10163099 A
- JP 10214783 A
- US 6341007 B
- US 6400441 B
- US 6549269 B
- US 6590634 B
- JP 2000505958 PCT
- US 5969441 A
- US 6208407 B
- US 6778257 B
- WO 2001035168 A
- JP 6124873 A
- US 5825043 A
- US 5623853 A
- US 5528118 A
- JP 8166475 A
- US 5874820 A
- JP 8330224 A